# EUROPEAN PATENT APPLICATION

(11) **EP 4 693 288 A1**
(43) Date of publication of application: **11.02.2026**
(21) Application number: 24818288.3
(22) Date of filing: 28.02.2024
(51) Int. Cl.: G11C 5/06

(54) **MEMORY MODULE, ELECTRONIC DEVICE, AND DATA MIGRATION METHOD**

(30) Priority: 09.06.2023 CN 202310685185; 30.01.2024 CN 202410133042
(71) Applicant: Huawei Technologies Co., Ltd., Shenzhen, Guangdong 518129 (CN)
(72) Inventor: BAO, Yunbing, Shenzhen, Guangdong 518129 (CN); LEI, Hubao, Shenzhen, Guangdong 518129 (CN); NIU, Yuanjun, Shenzhen, Guangdong 518129 (CN)
(74) Representative: Pfenning, Meinig & Partner mbB
(86) International application number: PCT/CN2024/079110
(87) International publication number: WO 2024/250751

(57) **Abstract**

A memory module, an electronic device, and a data migration method are provided, to implement a low-cost memory expansion solution of a server system. A solution in which cold and hot migration is jointly implemented by using a processing module in the memory module and a component outside the module can reduce working pressure of the processing module, and has a simpler research and development process and needs lower labor costs and research and development costs than a solution in which an integrated unit in a memory module is re-developed to independently implement cold and hot migration, to help implement the low-cost memory expansion solution of the server system. In addition, a power pin of a gold finger connector in the memory module is redefined as a pin whose width is greater than that of an original power pin, so that a through-current capability of the power pin can be improved, supply power of the power pin can be increased, and increased supply power can support arrangement of more storage media in the memory module, to further expand a memory of the server system.

## Description

### CROSS-REFERENCE TO RELATED APPLICATIONS

This application claims priorities to Chinese Patent Application No. 202310685185.3, filed with the China National Intellectual Property Administration on June 9, 2023 and entitled "MEMORY MODULE AND ELECTRONIC DEVICE", and to Chinese Patent Application No. 202410133042.6, filed with the China National Intellectual Property Administration on January 30, 2024 and entitled "MEMORY MODULE, ELECTRONIC DEVICE, AND DATA MIGRATION METHOD", both of which are incorporated herein by reference in their entireties.

### TECHNICAL FIELD

This application relates to the field of memory technologies, and in particular, to a memory module, an electronic device, and a data migration method.

### BACKGROUND

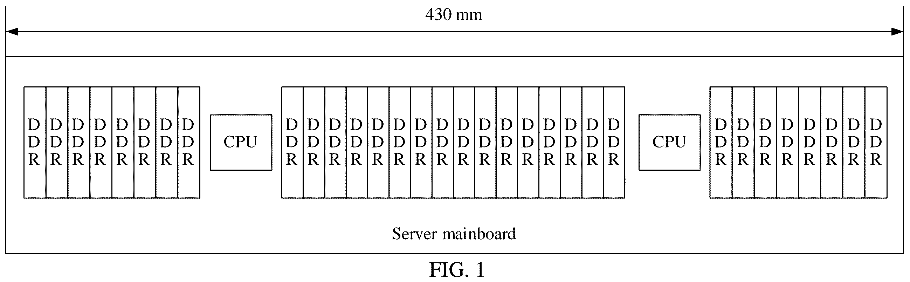

In a conventional server system, a memory and a central processing unit (central processing unit, CPU) are usually encapsulated together in a server mainboard. However, a quantity of memories that can be encapsulated with a processor is limited due to a rack size. For example, refer to FIG. 1. Currently, most mainstream servers are installed in a 19-inch rack, and the rack limits an upper limit of the width of the server mainboard to about 430 mm. Due to a limitation of the size, if a current mainstream memory control design with eight channels is used, in a 2-dual inline memory module (dual inline memory module, DIMM) per channel (DIMM per channel, DPC) mode, a maximum of 32 dual inline memory modules, for example, 32 double data rate synchronous dynamic random access memories (double data rate synchronous dynamic random access memories, DDR SRAMs) can be placed in the server mainboard. The DDR SRAM is briefly referred to as a DDR in FIG. 1. Although some CPUs can use a memory control design with a maximum of 12 channels, the system can support only a 1-DPC mode during implementation. If dual-processor configuration is implemented, a maximum of 24 DIMMs can be placed. In conclusion, it is difficult to improve memory performance and a memory capacity of the conventional server system.

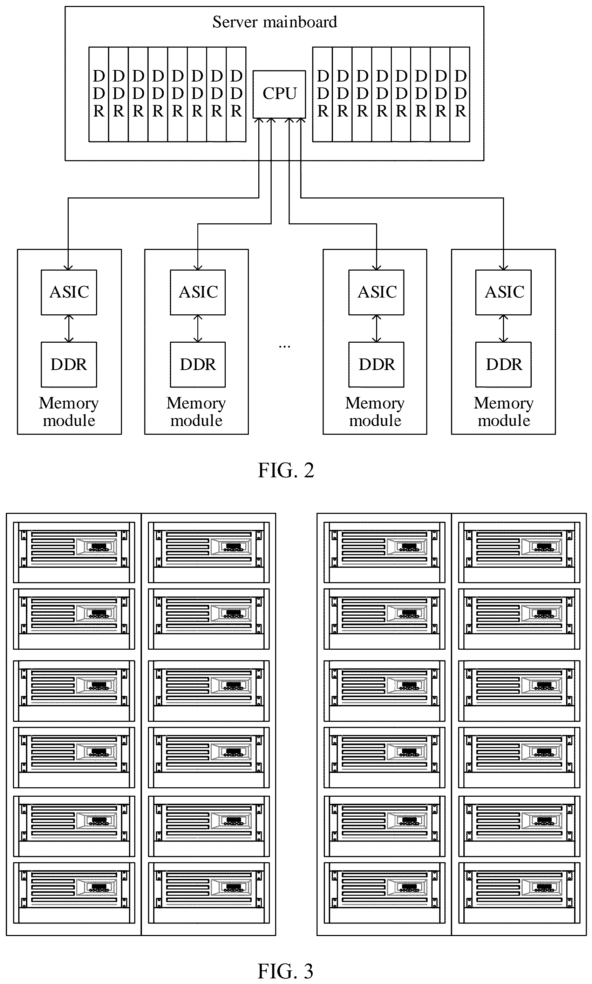

To resolve a problem of limited memory performance and a limited memory capacity in the conventional server system, a new server system is proposed in the industry. Refer to FIG. 2. In the new server system, a DDR is encapsulated in a server mainboard, and some memory modules are further disposed outside the server mainboard. An application-specific integrated circuit (application-specific integrated circuit, ASIC) and a DDR are encapsulated in each memory module, and a CPU is connected to the ASIC in each memory module through a serial bus, to implement access to the DDR in each memory module. Although expansion using more DDRs outside the server mainboard can be implemented in the new server system, the DDR in the memory module has a longer access delay than the DDR in the server mainboard. For example, accessing the DDR in the server mainboard usually needs only several nanoseconds (nanoseconds, ns). However, accessing the DDR in the memory module needs dozens of ns. Currently, there are also some solutions in which the ASIC in the memory module may be used to migrate frequently accessed data in the memory module in which the ASIC is located to the server mainboard, to reduce an access delay of the frequently accessed data. However, in these solutions, the ASIC in the memory module needs to be re-developed, labor costs and research and development costs that are needed are high. This is not conducive to implementing a low-cost design concept of a server system.

Therefore, currently, a low-cost memory expansion solution of the server system needs to be further researched.

### SUMMARY

This application provides a memory module, an electronic device, and a data migration method, to implement a low-cost memory expansion solution of a server system.

According to a first aspect, this application provides a memory module, including a processing module and a gold finger connector connected to the processing module. The gold finger connector is configured to be plugged to a component outside the memory module, to implement a communication connection between a component in the memory module and the component outside the memory module. The processing module is configured to: receive a read/write request from the component outside the memory module through the gold finger connector, access at least one storage medium in the memory module based on the read/write request, and transmit, to the component outside the memory module through the gold finger connector, access frequency information of each storage address corresponding to at least one storage medium in the memory module. The access frequency information of each storage address is used by the component outside the memory module to migrate data stored in a storage address whose access frequency is greater than a hotness threshold to a storage medium connected to a processor.

When a cold and hot migration function is implemented by using the memory module, the processing module in the memory module may be configured to transmit the access frequency information of the storage medium in the memory module to the component outside the module, to jointly complete cold and hot migration with the component outside the module. In this way, for the memory module, merely an information transmission function may be newly added on the basis of a function of accessing the storage medium. In comparison with a solution in which an ASIC in the memory module is re-developed to independently implement a memory migration function, development difficulty is lower, and lower additional development costs and labor costs may be introduced. In this way, low-cost memory expansion of a server can be implemented.

In a possible design, the processing module may include a first integrated unit and a second integrated unit. The first integrated unit is connected to at least one storage medium in the memory module, and the gold finger connector is connected to the first integrated unit and the second integrated unit. The first integrated unit is configured to: receive the read/write request from the component outside the memory module through the gold finger connector, and access at least one storage medium in the memory module based on the read/write request. The second integrated unit is configured to send, to the component outside the memory module through the gold finger connector, the access frequency information of each storage address corresponding to at least one storage medium in the memory module.

In the foregoing design, the first integrated unit may be understood as an ASIC in an existing memory module. The second integrated unit is newly added to the memory module, so that a cold and hot migration solution of the server may be implemented by developing the second integrated unit, without a need of re-developing the first integrated unit. In comparison with re-developing the first integrated unit, an operation of developing the second integrated unit has a simpler research and development process. For example, arrangement and cabling of original components in the first integrated unit do not need to be modified, there is no need to consider how to arrange positions of the components to avoid interference caused by the cold and hot migration function to an original function of the first integrated unit, and labor costs and research and development costs needed are lower. It can be learned that, the memory module can implement the cold and hot migration solution, improve memory performance of the server, and introduce as few additional costs as possible. This helps implement low-cost memory expansion of the server, without increasing working pressure of the first integrated unit in the memory module.

In a possible implementation of the foregoing design, one or more reserved pins of the gold finger connector are defined as an out-of-band communication pin, and the second integrated unit is connected to the out-of-band communication pin through an out-of-band communication bus. In this way, after the memory module is plugged to the component outside the memory module through the gold finger connector, the out-of-band communication bus may implement a connection between the second integrated unit and the gold finger connector, and implement a connection between the second integrated unit and the component outside the memory module. The second integrated unit may send, to the component outside the memory module through the connection, the access frequency information of each storage address of at least one storage medium in the memory module.

In a further possible implementation, the out-of-band communication pin transmits the access frequency information by using a differential signal. In this case, a pin B68 and a pin B69 of the gold finger connector may be defined as two transmit pins, and a pin A68 and a pin A69 of the gold finger connector may be defined as two receive pins. The second integrated unit is configured to: send the access frequency information of each storage address of at least one storage medium in the memory module to the gold finger connector through the pin B68 and the pin B69, to forward the access frequency information to the component outside the memory module through the gold finger connector, and receive returned information of the gold finger connector through the pin A68 and the pin A69. The returned information may be, for example, sent by the component outside the memory module to the gold finger connector. In this way, the differential signal may be transferred between the second integrated unit and the component outside the memory module through the two transmit pins and the two receive pins.

In a possible implementation of the foregoing design, the memory module may further include a control address line, and the first integrated unit is connected to at least one storage medium in the memory module through the control address line. The first integrated unit is specifically configured to access at least one storage medium in the memory module by adjusting a control address (control address, CA) signal on the control address line. The second integrated unit is specifically configured to determine, based on a change of the CA signal on the control address line, the access frequency information, within a preset time period, of the storage address corresponding to at least one storage medium in the memory module in which the second integrated unit is located. According to this design, because a read/write operation on the storage address is triggered and implemented by using the CA signal, the second integrated unit can detect an access status of each storage address in real time by monitoring the change of the CA signal, to help improve accuracy of collecting statistics on the access frequency information.

In a possible design, the processing module may include only one integrated unit, and the integrated unit is connected between at least one storage medium in the memory module and the gold finger connector. In this way, an original first integrated unit in the memory module may be simply modified, to jointly implement a cold and hot migration solution by using a modified first integrated unit and the component outside the module together. A structure of the processing module is simple, and communication between a plurality of integrated units is not needed. This helps reduce a communication loss.

It may be understood that the processing module may alternatively include three or more integrated units. Each integrated unit shares some functions of the processing module, and the three or more integrated units jointly implement all functions of the processing module. There are many possible implementations, which are not listed one by one herein.

In a possible design, a first positive pin exists in a region in which a pin B1 to a pin B6 of the gold finger connector are located, a first ground pin exists in a region in which a pin A1 to a pin A6 of the gold finger connector are located, widths of the first positive pin and the first ground pin are both greater than a preset width, and the preset width is a width of an original pin defined in a standard.

In the foregoing design, a power pin of the gold finger connector is redefined, so that a pin width of a power pin after redefinition is greater than the pin width of the original power pin defined in the standard, and an area of a conductive spring corresponding to the power pin can be increased, to improve a through-current capability of the power pin, and increase supply power of the power pin. In addition, increased supply power can support arrangement of more storage media in the memory module, to further expand a storage capacity of the memory module.

In a possible implementation of the foregoing design, considering that there are six groups of original power pins, a quantity of power pins after redefinition may be any value less than 6. It is assumed that the preset width is K. In this case:

In some possible implementations, there is one group of power pins after redefinition. In this case, the widths of the first positive pin and the first ground pin may be both configured as 11K. For example, if the width of the original pin is 0.3 mm, the first positive pin and the first ground pin may be both configured as 3.3 mm. In this way, only one group of power pins is arranged in the region in which the original B1 pin to the original B6 pin of the gold finger connector are located, so that pin widths of the group of power pins can be maximized, and the through-current capability of the power pin can be maximized, to maximize a power supply capability.

In some other possible implementations, there are two groups of power pins after redefinition. In this case, widths of each first positive pin and each first ground pin may be both configured as 5K, or widths of one first positive pin and one first ground pin may be configured as 7K, and widths of the other first positive pin and the other first ground pin may be configured as 3K. For example, if the width of the original pin is 0.3 mm, widths of two first positive pins and two first ground pins may be all configured as 1.5 mm, or widths of one first positive pin and one first ground pin are configured as 2.1 mm, and widths of the other first positive pin and the other first ground pin are configured as 0.9 mm. In this way, two groups of power pins are arranged in the region in which the original B1 pin to the original B6 pin of the gold finger connector are located, so that pin widths of the power pins can be increased, power supply capabilities of the power pins can be improved, and a gold finger connector can be better plugged and unplugged than a gold finger connector having only one group of power pins. In addition, widths of the two groups of power pins are configured to be all greater than the width of the original power pin, so that power supply capabilities of each group of power pins can be greater than a power supply capability of the original power pin. In this way, even if only one of the groups of power pins is used for power supply, a good power supply effect can be achieved.

In still some possible implementations, there are three groups of power pins after redefinition. In this case, widths of each first positive pin and each first ground pin may be both configured as 3K. For example, if the width of the original pin is 0.3 mm, three first positive pins and three first ground pins may be all configured as 0.9 mm. In this way, three groups of power pins are arranged in the region in which the original B1 pin to the original B6 pin of the gold finger connector are located, so that pin widths of the power pins can be increased, power supply capabilities of the power pins can be improved, and a gold finger connector has a smaller friction force than a gold finger connector having only one or two groups of power pins, to implement flexible plugging and unplugging of the gold finger connector more easily. In addition, the three groups of power pins are configured to have a same width, so that the three groups of power pins can further have a same power supply capability. This helps implement balance of power supply of different power pins on the gold finger connector.

It should be noted that, there may alternatively be more than three groups of power pins after redefinition, for example, there may alternatively be four or five groups of power pins. However, in a solution of four or five groups of power pins, widths of one or more groups of power pins are the same as the width of the original power pin. Improvement performance of the solution on the power supply capability is limited, but plugging and unplugging are more convenient. Therefore, in some possible designs, in a scenario with a high requirement on plugging and unplugging, four or five groups of power pins may be configured, to meet a requirement for flexible plugging and unplugging. In a scenario with a high requirement on the power supply capability, one, two, or three groups of power pins may be configured, to meet a high power supply requirement.

In a possible implementation of the foregoing design, the first positive pin and the first ground pin may be implemented by gold-plated copper, so that the power pin has advantages of a beautiful appearance, good anti-corrosion performance, wear resistance, and convenient maintenance.

According to a second aspect, this application provides an electronic device. The electronic device may be any device having a cold and hot migration function, for example, a server, or a computer device having a display screen and a server. The electronic device may include the memory module in any one of the first aspect or the designs of the first aspect.

In a possible design, the electronic device may further include an electronic device mainboard and a media management board. The electronic device mainboard includes a processor and at least one first storage medium, the memory module includes at least one second storage medium, a quantity of memory modules is N, and N is a positive integer. Any memory module is configured to send access frequency information of each second storage address corresponding to at least one second storage medium in the memory module within a preset time period to the media management board. The media management board is configured to send access frequency information of each second storage address corresponding to each second storage medium in the N memory modules within the preset time period to the processor. The processor is configured to: migrate, based on access frequency information of each first storage address corresponding to the at least one first storage medium within the preset time period and the access frequency information of each second storage address corresponding to each second storage medium in the N memory modules within the preset time period, data stored in a target second storage address whose access frequency is greater than a hotness threshold to the first storage medium, and migrate data stored in a target first storage address whose access frequency is less than a coldness threshold to the second storage medium.

In the foregoing solution, a delay of access of the processor to the first storage medium in the electronic device mainboard is less than a delay of access of the processor to the second storage medium in the memory module. Therefore, hot data in the memory module is migrated to the electronic device mainboard, so that the processor can access data with high heat more quickly, and data access performance can be improved. Cold data in the electronic device mainboard is migrated to the memory module, so that occupation of the cold data in the electronic device mainboard can also be released, and a storage capacity of the hot data can be increased.

In a possible design, a processing module includes a first integrated unit and a second integrated unit. The first integrated unit in the any memory module is configured to access the at least one second storage medium in the memory module in which the first integrated unit is located. The second integrated unit in the any memory module is configured to send, to the media management board, the access frequency information, within the preset time period, of each second storage address corresponding to the at least one second storage medium in the memory module in which the second integrated unit is located.

In the foregoing design, in comparison with a cold and hot migration solution of a new server system, in this manner, one second integrated unit is additionally added to an existing memory module, frequently accessed data in the second storage medium in the memory module in which the second integrated unit is located may be migrated to the first storage medium in the electronic device mainboard through the second integrated unit, and there is no need to re-develop the first integrated unit in the memory module. In comparison with re-developing the first integrated unit, an operation of developing the second integrated unit has a simpler research and development process, and needs low labor costs and research and development costs. It can be learned that, this solution can not only improve memory performance of the server, but also introduce as low additional costs as possible. This helps implement a low-cost memory expansion solution of a server system.

In a possible design, the media management board may include a third integrated unit and a fourth integrated unit, the third integrated unit is separately connected to the fourth integrated unit and the second integrated unit in each memory module, and the fourth integrated unit is further connected to the processor. The third integrated unit is configured to: receive the access frequency information that is sent by the second integrated unit in each memory module and that is of each second storage address in the memory module within the preset time period, collect the access frequency information of each second storage address in the N memory modules within the preset time period, and send the collected access frequency information to the fourth integrated unit. The fourth integrated unit is configured to send the collected access frequency information of each second storage address in the N memory modules within the preset time period to the processor.

In the foregoing design, the third integrated unit may be understood as an integrated unit in an existing media management board. The fourth integrated unit is additionally added to the media management board, access frequency corresponding to each memory module may be sent to the processor through the fourth integrated unit, and the third integrated unit does not need to perform forwarding, to reduce impact on an original communication procedure of the third integrated unit as much as possible. In other words, this design can implement a cold and hot migration solution based on an original component architecture of the server as much as possible, reduce re-development of an original component, and minimize impact on a function of the original component.

In a further possible design, the fourth integrated unit and the processor may be connected through a universal serial bus (universal serial bus, USB) or a peripheral component interconnect express (peripheral component interconnect express, PCIe) bus, to implement a communication connection between the fourth integrated unit and the processor, and also reduce costs and improve communication quality.

It may be understood that, in another possible design, the media management board may alternatively include only one integrated unit. The integrated unit is separately connected to the processing module in each memory module and the processor in the electronic device mainboard, and is configured to: receive the access frequency information that is sent by the processing module in each memory module and that is of each second storage address in the memory module within the preset time period, collect the access frequency information of each second storage address in the N memory modules within the preset time period, and send the collected access frequency information to the processor in the electronic device mainboard. In this design, a structure of the media management board is simple, and communication between a plurality of integrated units is not needed. This helps reduce a communication loss. Alternatively, in still another possible design, the media management board may include three or more integrated units. Each integrated unit shares some functions of the media management board, and the three or more integrated units jointly implement all functions of the media management board. There are many possible implementations, which are not listed one by one herein.

According to a third aspect, this application provides a data migration method. The method may be performed by the memory module in any one of the first aspect or the designs of the first aspect, or may be performed by the electronic device in any one of the second aspect or the designs of the second aspect. The method includes: obtaining a cold and hot migration instruction, where the cold and hot migration instruction carries at least one of cold data in a first storage address associated with a processor or address information of a second storage address associated with the memory module; sending hot data in the second storage address to the processor in the electronic device based on the address information of the second storage address carried in the cold and hot migration instruction; and storing, in the second storage address, the cold data in the first storage address carried in the cold and hot migration instruction.

Herein, "associated" may be understood as "logically connected" or "functionally accessible". For example, the first storage address associated with the processor is a storage address that can be directly accessed by the processor in an electronic device mainboard, for example, may be a storage address located in the electronic device mainboard. The storage address is directly connected to the processor in the electronic device mainboard, and internal data of the storage address may be directly accessed by the processor in the electronic device mainboard. Similarly, the second storage address associated with the memory module is a storage address that can be directly accessed by a processing module in the memory module, for example, may be a storage address located in the memory module. The storage address is directly connected to the processing module in the memory module, and internal data of the storage address may be directly accessed by the processing module in the memory module.

In a possible design, before obtaining the cold and hot migration instruction, the method may further include: accessing one or more second storage addresses associated with the memory module, and sending access frequency information of each second storage address associated with the memory module to a media management board in the electronic device.

According to a fourth aspect, this application provides a cold and hot data migration apparatus. The cold and hot data migration apparatus may be a processing apparatus in a memory module, for example, a processing module. The apparatus includes: an obtaining module, configured to obtain a cold and hot migration instruction, where the cold and hot migration instruction carries at least one of cold data in a first storage address associated with a processor or address information of a second storage address associated with the memory module; a transceiver module, configured to send hot data in the second storage address to the processor in the electronic device based on the address information of the second storage address carried in the cold and hot migration instruction; and a storage module, configured to store, in the second storage address, the cold data in the first storage address carried in the cold and hot migration instruction.

According to a fifth aspect, this application provides a computer-readable storage medium. The computer-readable storage medium stores a computer program, and when the computer program is run by a cold and hot data migration apparatus, the method according to the third aspect or any one of the third aspect is implemented.

According to a sixth aspect, this application provides a computer program product. When the computer program product runs on a data migration apparatus, the method according to the third aspect or any one of the third aspect is implemented.

The designs in the first aspect are also applicable to the second aspect to the sixth aspect. For corresponding beneficial effects, refer to technical effects that can be achieved by corresponding designs in the first aspect. Details are not described herein again.

### BRIEF DESCRIPTION OF DRAWINGS

FIG. 1 is an example of a diagram of an arrangement manner of a server mainboard in a rack;
FIG. 2 is an example of a diagram of a system architecture of a new server;
FIG. 3 is an example of a diagram of an application scenario of a server according to this application;
FIG. 4 is an example of a diagram of a system architecture of a server according to this application;
FIG. 5a is an example of a diagram of a specific architecture of a server according to this application;
FIG. 5b is an example of a diagram of a specific architecture of another server according to this application;
FIG. 6a is an example of a diagram of a product structure of a memory module according to this application;
FIG. 6b is an example of a diagram of a product structure of another memory module according to this application;
FIG. 7 is an example of a diagram of structure comparison of a gold finger connector before and after redefinition according to this application;
FIG. 8 is an example of a diagram of a possible case of a power pin before and after redefinition according to this application;
FIG. 9 is an example of a schematic flowchart of interaction of a cold and hot migration solution according to this application;
FIG. 10 is an example of a diagram of an internal circuit of a memory module according to this application;
FIG. 11 is an example of a diagram of an internal circuit of another memory module according to this application; and
FIG. 12 is an example of a diagram of a structure of a data migration apparatus according to this application.

### DESCRIPTION OF EMBODIMENTS

The following describes in detail this application with reference to the accompanying drawings.

Some terms in this application are explained and described below. It should be noted that these explanations are for ease of understanding by a person skilled in the art, and are not intended to limit the protection scope claimed by this application.

### 1. Storage medium and storage address

The storage medium is generally made of a semiconductor material, and is configured to temporarily store operation data and exchange data with an external memory like a hard disk. The storage medium includes a plurality of types of memories, for example, a dynamic random access memory (dynamic random access memory, DRAM) and a double data rate synchronous dynamic random access memory (double data rate synchronous dynamic random access memory, DDR SRAM). The DDR SRAM is generally also referred to as a DDR for short.

The storage address is an identifier of a storage position, and data stored in the storage medium can be found by using an index of the storage address. In some scenarios, the storage medium includes a plurality of memory cells, and each memory cell may have a storage address of the memory cell. For example, hexadecimal is used as an example. It is assumed that a complete storage medium includes 17 memory cells, and physical addresses of these memory cells are sequentially 0x0000 to 0x0010. In this case, 0x0000 represents a storage address of a 1^{st} memory cell of the storage medium, 0x0001 represents a storage address of a 2^{nd} memory cell of the storage medium, ..., and 0x0010 represents a storage address of a 17^{th} memory cell of the storage medium. Certainly, with development of storage technologies, the storage address of the memory cell may be expressed in a virtual address manner in the future, and a physical address corresponding to a virtual address may be found by querying a preset address mapping table.

### 2. Memory controller (memory controller)

The memory controller is configured to manage data exchange between a storage medium and a processing unit. The memory controller may be an independent chip, or may be integrated into the storage medium or the processing unit. Still refer to FIG. 2. In a new server system, a server mainboard and a memory module each may have a memory controller. The memory controller in the server mainboard may be, for example, integrated into a central processing unit (central processing unit, CPU), and the memory controller in the memory module may be, for example, integrated into an application-specific integrated circuit (application-specific integrated circuit, ASIC).

### 3. Gold finger connector (connecting finger)

The gold finger connector is also referred to as an edge-board connector, is usually used in a scenario in which a storage medium is connected to a slot and a graphics card is connected to a graphics card slot, and is used for transmission of all signals between two connected components. The gold finger connector generally includes many golden-yellow conductive springs. Because a surface of the gold finger connector is gold-plated and the conductive springs are arranged in a finger shape, the gold finger connector is commonly referred to as a "gold finger connector".

The foregoing describes some terms used in this application, and the following describes possible application scenarios of this application.

In a possible implementation, the memory module may be integrated into a server, for example, may be placed in a memory slot inside a server housing, and is plugged to the server mainboard. FIG. 3 is an example of a diagram of a possible application scenario according to this application. In this application scenario, an example in which a server is a rack server and the rack server is placed in a reserved position in the middle of a rack is used. It may be understood that the rack server may alternatively be placed at another position of the rack, for example, an outer side of any one or more of four directions: up, down, left, and right, to reduce a quantity of disposed racks.

It should be understood that the foregoing application scenario is merely an example. The memory module provided in this application may be further used in another possible scenario, and is not limited to the scenario in the foregoing example. For example, the memory module may alternatively be integrated into any type of server like a tower server, a blade server, a high-density server, or a cabinet server. For another example, the memory module may alternatively be integrated into a non-server, for example, integrated into a terminal device, and used as an additional memory obtained through expansion, to improve a storage capability of the terminal device. For another example, the memory module may alternatively be integrated into a vehicle, and is used as a medium for storing inherent information of the vehicle or other non-key information, to expand storage space of the vehicle. Examples are not listed one by one herein. It should be noted that the application scenario described in this application is intended to describe the technical solutions in this application more clearly, and does not constitute a limitation on the technical solutions provided in this application.

In recent years, with continuous development of a semiconductor technology, a processing capability and a quantity of cores of a processor basically increase by two to three times every two years. However, development of a memory technology is slow, and basically increases by two to three times every three years. After years of asynchronous development, although a total memory capacity of the server is increased, actually, a memory capacity of each core in an internal processor of the server is decreasing gradually. In particular, a memory bandwidth of the server is decreasing more clearly. Consequently, a delay of accessing the memory by the processor is not reduced, but is increased by 30%.

To cope with such unbalanced development of the processor and the memory, the new server system shown in FIG. 2 is proposed in the industry. However, as described in the background, in this new server system, the ASIC in the memory module needs to be re-developed, so that in addition to accessing a DDR in the memory module in which the ASIC is located, the ASIC needs to migrate frequently accessed data in the DDR in the memory module in which the ASIC is located to a DDR in the server mainboard. In this case, a device arrangement in the original ASIC in the memory module needs to be manually modified. Not only a new device needs to be added to implement a new function, but also anti-interference of signal transmission between devices during implementation of two functions needs to be considered. Although memory access performance of the server is improved, huge labor costs and research and development costs are brought, and great working pressure is brought to the ASIC in the memory module.

In view of the foregoing problem, this application provides a memory module. The memory module may not change the ASIC in the existing memory module, or may only slightly change the ASIC in the existing memory module, to jointly implement a cold and hot migration solution with a component outside the module, so that no additional costs are introduced as much as possible in a memory expansion process, and working pressure of the memory module is reduced.

Based on the foregoing content, the following describes in detail the solutions provided in this application with reference to the accompanying drawings.

It should be noted that a "first storage medium" in the following is a storage medium in an electronic device mainboard (for example, the server mainboard), the first storage medium is connected to a processor in the electronic device mainboard, and internal data of the first storage medium may be directly accessed by the processor in the electronic device mainboard. A "second storage medium" is a storage medium in the memory module. The second storage medium is connected to a processing module in the memory module, and internal data of the second storage medium may be directly accessed by the processing module in the memory module. Therefore, the "first storage medium" in the following may also be replaced with the storage medium in the electronic device mainboard, a storage medium associated with the processor, a storage medium connected to the processor, or another similar name, and the "second storage medium" may also be replaced with the storage medium in the memory module, a storage medium associated with the memory module, a storage medium connected to the processing module in the memory module, or another similar name. This is not specifically limited in this application. In addition, an implementation form of the first storage medium or the second storage medium may be a memory, or may be an external memory. This is not specifically limited.

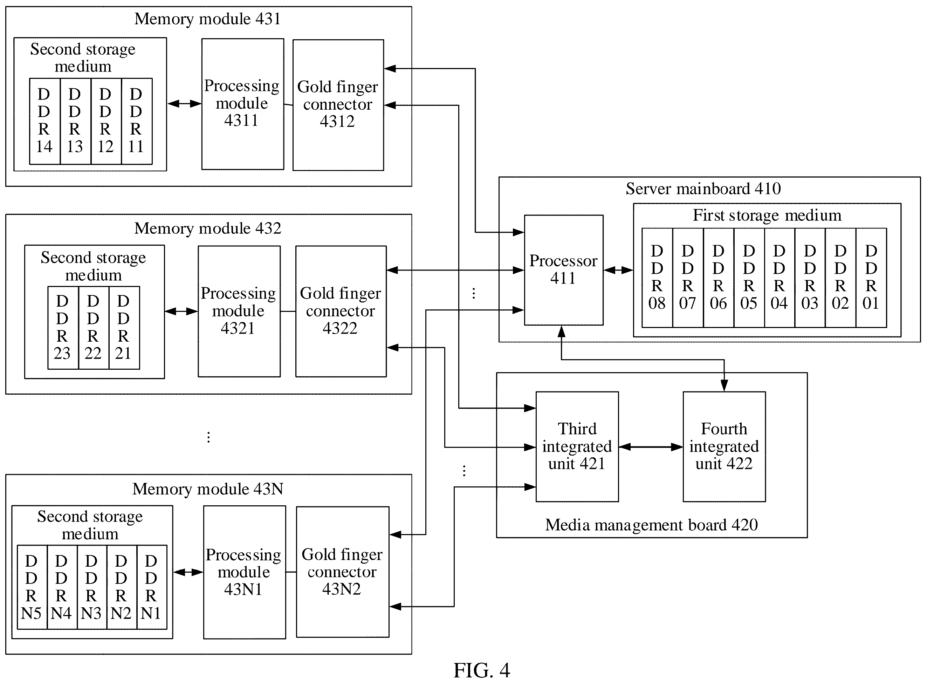

FIG. 4 is a diagram of a system architecture of a server according to this application. The system architecture includes a server mainboard 410, a media management board 420, and N memory modules, such as a memory module 431, a memory module 432, ..., and a memory module 43N, where N is a positive integer. From a perspective of the memory module, the server mainboard 410 and the media management board 420 may be considered as components outside the memory module. The following first describes structures and connection relationships of components in a server system.

The server mainboard 410, also referred to as a mainboard (mainboard), a system board (system board), or a motherboard (motherboard), is installed in a chassis and is a core component of the server. The server mainboard 410 may include a processor 411 and at least one first storage medium. In FIG. 4, an example in which eight first storage media are included and the first storage medium is a DDR is used, and the eight first storage media are named as a DDR 01, a DDR 02, ..., and a DDR 08. The processor 411 may be, for example, a CPU. In some scenarios, the processor 411 may alternatively be a graphics processing unit (graphics processing unit, GPU), a neural network processing unit (neural network processing unit, NPU), or the like. The processor 411 may be separately connected to the DDR 01 to the DDR 08. Specifically, the processor 411 may be connected to the DDR 01 to the DDR 08 through a memory controller integrated into the processor 411. For example, when a 2DPC mode is used, one memory controller may be connected to two DDRs. Therefore, four memory controllers need to be integrated into the processor 411. For another example, when a 1-DPC mode is used, one memory controller may be connected to one DDR. Therefore, eight memory controllers need to be integrated into the processor 411. Because the DDR 01 to the DDR 08 are close to the processor 411, and can be directly accessed by the processor 411, in some scenarios, the DDR 01 to the DDR 08 are also referred to as near-end memories or one level (one level, L1) memories of the processor 411.

The media management board 420 is an integrated board configured to manage storage media such as a hard disk and the memory module in the server, and may be configured to manage a temperature, an occupation amount, an indicator status, and the like of these storage media. The media management board 420 may include a third integrated unit 421 and a fourth integrated unit 422. The third integrated unit 421 may be, for example, an original complex programmable logic device (complex programmable logic device, CPLD) (not shown in FIG. 2) in the new server system shown in FIG. 2, or another unit or module having a processing capability, and is configured to implement an original management operation on the storage medium. The fourth integrated unit 422 may be, for example, an ASIC, or another unit or module having a processing capability, and is a component additionally added to the new server system shown in FIG. 2. In addition, on a basis of newly adding the fourth integrated unit 422 to the media management board 420, a local bus (Local Bus) and an external bus (External Bus) may be additionally added. The local bus is configured to connect the fourth integrated unit 422 and the third integrated unit 421, and the external bus is configured to connect the fourth integrated unit 422 and the processor 411 that is in the server mainboard 410. A type of the external bus may be, for example, a universal serial bus (universal serial bus, USB) or a peripheral component interconnect express (peripheral component interconnect express, PCIe) bus, or may be another type of full-duplex communication bus, for example, a universal asynchronous receiver/transmitter (universal asynchronous receiver/transmitter, UART) bus, an inter-integrated circuit (inter-integrated circuit, I²C) bus, or a serial peripheral interface (serial peripheral interface, SPI) bus. This is not specifically limited.

It may be understood that the media management board 420 may alternatively include only one integrated unit, or include three or more integrated units. When only one integrated unit is included, the integrated unit is configured to perform all work of the third integrated unit 421 and the fourth integrated unit 422 in this application. When three or more integrated units are included, each integrated unit is configured to share a part of work of the media management board 420, and the three or more integrated units jointly complete all work of the media management board 420. The following provides descriptions only by using an example in which the media management board 420 includes two integrated units. Other solutions may be performed with reference to the example. Examples are not described in this application.

The memory module is a module that is placed outside the server mainboard 410 and that is configured to expand a memory (or a memory and an external memory). The memory module may include a processing module, at least one second storage medium, and a gold finger connector. When the server includes a plurality of memory modules, quantities of second storage media in different memory modules may be the same or may be different. For example, in the example in FIG. 4, the memory module 431 includes four second storage media, the memory module 432 includes three second storage media, the memory module 43N includes five second storage media, and quantities of second storage media included in the memory modules may be different. However, this is merely an optional implementation. In an actual product, at least two memory modules may include a same quantity of second storage media, or all memory modules include a same quantity of second storage media. This is not specifically limited.

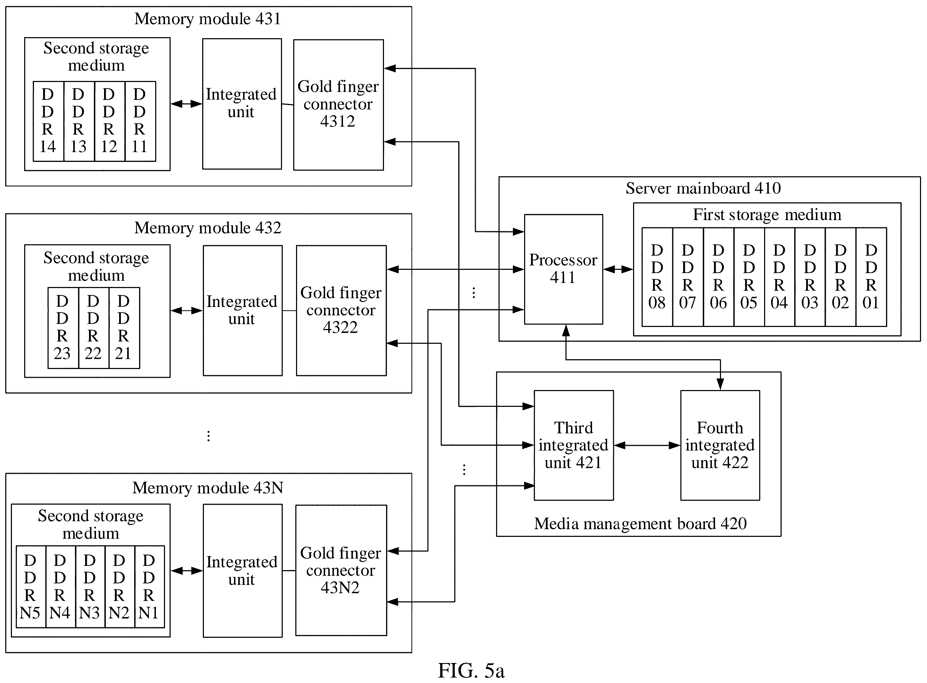

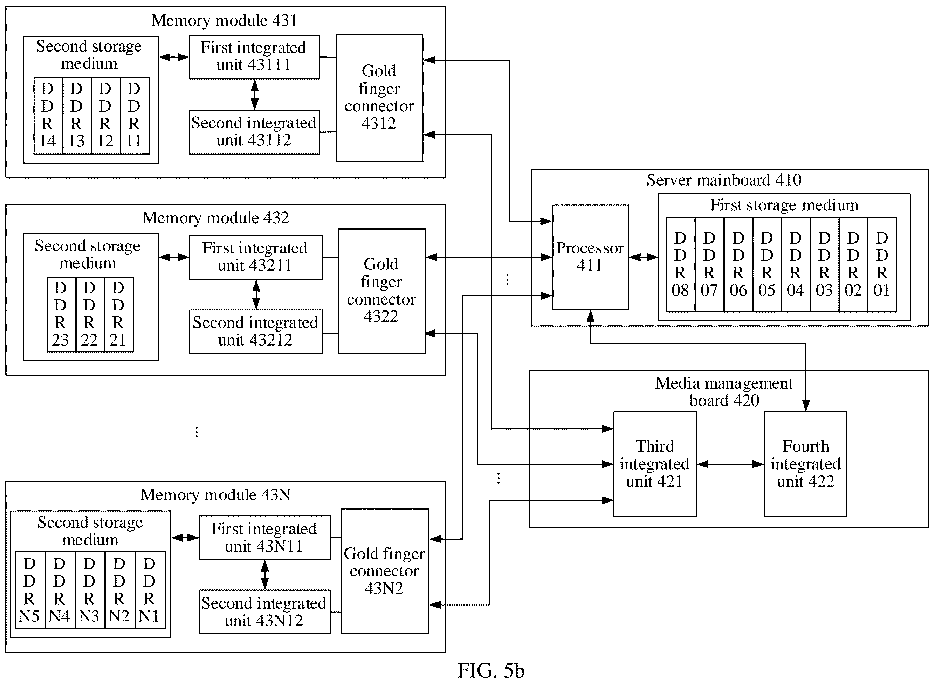

The memory module 431 is used as an example. The memory module 431 includes a processing module 4311, a gold finger connector 4312, and four second storage media. The four second storage media are respectively named as a DDR 11, a DDR 12, a DDR 13, and a DDR 14. The processing module 4311 may include one or more integrated units. For example, only one integrated unit is included. Refer to FIG. 5a. The integrated unit may be connected between the gold finger connector 4312 and at least one of the second storage media DDR 11 to DDR 14. The integrated unit may be understood as an ASIC in the existing memory module, or may be any other circuit or chip that can implement a processing function, for example, may be an FPGA. For another example, two integrated units are included. Refer to FIG. 5b. The processing module 4311 may include a first integrated unit 43111 and a second integrated unit 43112. The first integrated unit 43111 may be, for example, an ASIC, for example, an original ASIC in the memory module in the new server system shown in FIG. 2, or another unit or module having a processing capability. The first integrated unit 43111 may be separately connected to the DDR 11 to the DDR 14, for example, may be connected to the DDR 11 to the DDR 14 through a memory controller integrated into the first integrated unit 43111. The first integrated unit 43111 may be further connected to the processor 411 in the server mainboard 410, for example, connected to the processor 411 through a serial bus X4 with four memory channels, a serial bus X8 with eight memory channels, a serial bus X16 with 16 memory channels, or the like, and the gold finger connector 4312. Because the second storage medium is far away from the processor 411, the processor 411 needs to indirectly access the second storage medium by communicating with the first integrated unit 43111. Therefore, in some scenarios, the second storage medium is also referred to as a remote-end memory or a two level (two level, L2) memory of the processor 411. In addition, the second integrated unit 43112 may be, for example, a programmable logic array (field programmable gate array, FPGA), or another unit or module having a processing capability, and is a component additionally added to the memory module 431 in the new server system shown in FIG. 2. In addition, on a basis of newly adding the second integrated unit 43112 to the memory module 431, a local bus and an out-of-band communication bus may be additionally added. The local bus is configured to connect the second integrated unit 43112 and the first integrated unit 43111, and the out-of-band communication bus is configured to implement a connection between the second integrated unit 43112 and the third integrated unit 421 in the media management board 420. The out-of-band communication bus may be any type of full-duplex communication bus, for example, a high-speed interconnection bus (for example, a Hisport bus), a UART bus, an I²C bus, or an SPI bus. This is not specifically limited.

In some scenarios, in addition to the processing module, the gold finger connector, and the second storage medium, each memory module may further include a printed circuit board (printed circuit board, PCB). For example:

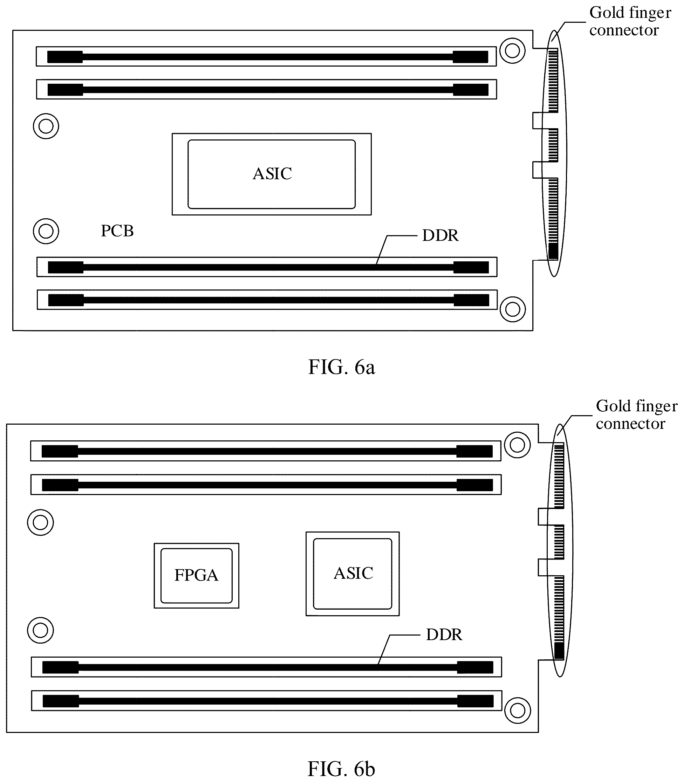

In an example, FIG. 6a is a diagram of a product structure of a memory module according to this application. In this structure, an example in which the processing module includes only one integrated unit is used. For example, the integrated unit may be an ASIC shown in the figure, or may be any other circuit or chip that can implement a processing function, for example, may be an FPGA. This is not specifically limited. For example, the integrated unit is the ASIC. The ASIC may be placed in a middle region of the PCB, and at least one second storage medium may be evenly distributed on two sides of the ASIC. For example, when the second storage medium is a DDR and the memory module includes four DDRs, the four DDRs may be evenly distributed in a region above and a region below the ASIC. For example, two DDRs are placed in the region above the ASIC, and two DDRs are placed in the region below the ASIC.

In another example, FIG. 6b is a diagram of a product structure of another memory module according to this application. In this structure, an example in which the processing module includes two integrated units, one integrated unit is an ASIC, and the other integrated unit is an FPGA is used. As shown in FIG. 6b, the ASIC and the FPGA may be placed side by side in a middle region of the PCB, and at least one second storage medium is evenly distributed on two sides of the ASIC and the FPGA. For example, when the second storage medium is a DDR and the memory module includes four DDRs, the four DDRs may be evenly distributed in a region above and a region below the ASIC and the FPGA. For example, two DDRs are placed in the region above the ASIC and the FPGA, and two DDRs are placed in the region below the ASIC and the FPGA.

Further, the gold finger connector may be arranged at any edge position of the PCB, for example, an edge of any one or more of four directions: up, down, left, and right. For example, in FIG. 6a and FIG. 6b, the gold finger connector is arranged on a right edge of the PCB. Three small rectangular regions may be protruded side by side on the right edge of the PCB, and a part of conductive springs are pasted on a right edge of each small rectangular region. Positions and functions of these conductive springs are defined, so that the defined conductive springs may be plugged to the server mainboard 410 and the media management board 420, to implement communication connections between the memory module and the server mainboard 410 and between the memory module and the media management board 420. For example, the processing module in the memory module shown in FIG. 4 is separately in communication connection with the processor 411 in the server mainboard 410 and the third integrated unit 421 in the media management board 420, the integrated unit in the memory module shown in FIG. 5a is separately in communication connection with the processor 411 in the server mainboard 410 and the third integrated unit 421 in the media management board 420, or the first integrated unit in the memory module shown in FIG. 5b is connected to the processor 411 in the server mainboard 410, and the second integrated unit in the memory module shown in FIG. 5b is connected to the third integrated unit 421 in the media management board 420. In addition, a function of supplying power to each component in the memory module by an external power supply and some other functions may be further implemented. The gold finger connector is disposed in the memory module, so that the memory module can be flexibly plugged or unplugged, to implement connection or disconnection between the memory module and the server mainboard and between the memory module and the media management board.

It may be understood that structures of the memory module 432 to the memory module 43N are similar to that of the memory module 431. For example, refer to FIG. 4. The memory module 432 may include a processing module 4321, a gold finger connector 4322, and three second storage media, which are respectively named as a DDR 21, a DDR 22, and a DDR 23; ...; and the memory module 43N may include a processing module 43N1, a gold finger connector 43N2, and five second storage media, which are respectively named as a DDR N1, a DDR N2, a DDR N3, a DDR N4, and a DDR N5. For example, the processing module in each memory module includes two integrated units. Refer to FIG. 4 and FIG. 5b. The processing module 4321 in the memory module 432 may include a first integrated unit 43211 and a second integrated unit 43212, ..., and the processing module 43N1 in the memory module 43N may include a first integrated unit 43N11 and a second integrated unit 43N12.

In addition, the components shown in FIG. 5a and FIG. 5b and positions of the components are merely a possible division manner of the server system. The division manner is merely logical function division. During actual implementation, all or some of the components may be integrated into a physical entity, or may be physically separated. For example, in still another example, the processing module in each memory module may alternatively include three or more integrated units, each integrated unit shares some functions of the processing module, and the three or more integrated units jointly implement all functions of the processing module. For another example, in yet another example, the media management board 420 may alternatively include only one integrated unit, and the integrated unit completes all functions of the media management board 420. Alternatively, the media management board 420 may include three or more integrated units, each integrated unit shares some functions of the media management board 420, and the three or more integrated units jointly implement all functions of the media management board 420.

In addition, processing modules in different memory modules may include a same quantity or different quantities of integrated units. For example, the processing module in the memory module 431 includes one integrated unit, and the processing module in the memory module 432 includes two integrated units; the processing module in the memory module 431 includes two integrated units, and the processing module in the memory module 432 includes one integrated unit; the processing module in the memory module 431 includes one integrated unit, and the processing module in the memory module 432 includes three integrated units; and so on. Examples are not listed one by one herein.

In addition, FIG. 4, FIG. 5a, or FIG. 5b merely describes an example of key components in the server mainboard 410, the media management board 420, or the memory module. The server mainboard 410, the media management board 420, or the memory module may alternatively include more or fewer components than those shown in the figure. For example, in some scenarios, the server mainboard 410 may further include a power supply, an input/output (input/output, I/O) bus, a hard disk drive, and the like. In some other scenarios, in addition to the server mainboard 410, the media management board 420, and the memory module, the server may further include a disk, a hard disk, a chassis housing, or the like. There are many possible cases, which are not listed one by one herein.

In addition, FIG. 4, FIG. 5a, or FIG. 5b merely describes a possible architecture of an electronic device by using the server as an example. When the electronic device is another device, the server mainboard may also be synchronously replaced with another mainboard. In other words, the server mainboard may be understood as an electronic device mainboard. When the electronic device is the server, the electronic device mainboard may be specifically the server mainboard. When the electronic device is a mobile phone, the electronic device mainboard may be specifically a mobile phone mainboard. When the electronic device is a computer, the electronic device mainboard may be specifically a computer mainboard. The rest can be deduced by analogy. Examples are not listed one by one in this application.

The foregoing content describes a difference between the server provided in this application and the existing new server shown in FIG. 2 in a system architecture. In addition to the difference in the system architecture, in this application, a part of pins of the gold finger connector in the memory module in the server are further redefined.

The following uses an example in which the gold finger connector is defined in compliance with an enterprise and data center solid-state drive form factor (enterprise & data center SSD form factor, EDSFF) to describe in detail differences between structures and pin definitions of the gold finger connector before and after redefinition. It should be noted that the EDSFF is merely an example, and does not constitute a limitation on the technical solutions to be protected in this application. During specific implementation, a customized standard, or another standard specification according to which a function of the gold finger connector to be protected in this application can be implemented may alternatively be used.

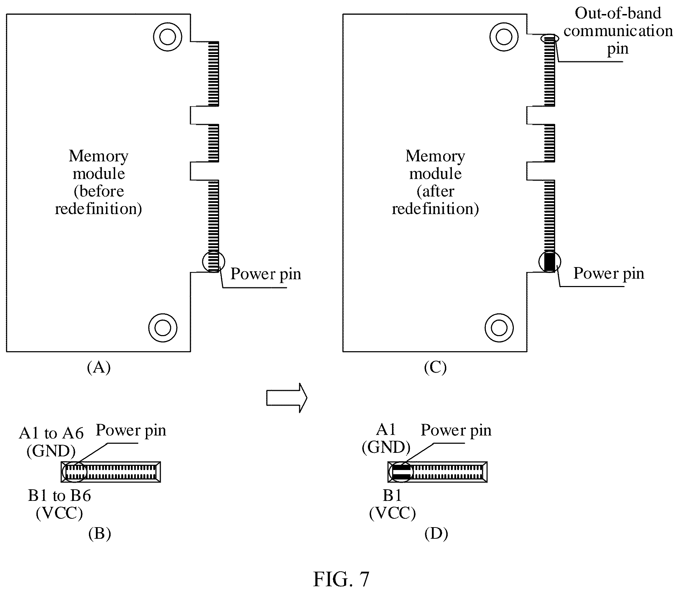

FIG. 7 is a diagram of structure comparison of a gold finger connector before and after redefinition according to this application. (A) in FIG. 7 is a top view of the gold finger connector before redefinition, (B) in FIG. 7 is a right view of a part of regions of the gold finger connector before redefinition, (C) in FIG. 7 is a top view of a gold finger connector after redefinition, and (D) in FIG. 7 is a right view of a part of regions of the gold finger connector after redefinition. It can be learned from comparison that differences between the gold finger connector after redefinition and the gold finger connector before redefinition mainly include the following two points.

In a possible embodiment, this application provides a gold finger connector having less than six groups of power pins.

Refer to (A) in FIG. 7 and (B) in FIG. 7. The gold finger connector before redefinition has six groups of power pins, and each group of power pins includes one positive pin (VCC) and one ground pin (GND). According to the EDSFF specification, positions and input signals of the six groups of power pins are shown in Table 1.1 below. It is assumed that a width of each power pin defined in the standard is 0.3 mm (that is, a preset width K). In this case, parameter information of the six groups of power pins is shown in Table 1.2 below.

**Table 1.1**

| Pin | Signal | Signal | Pin |
|---|---|---|---|
| B1 | 12 V | GND | A1 |
| B2 | 12 V | GND | A2 |
| B3 | 12 V | GND | A3 |
| B4 | 12 V | GND | A4 |
| B5 | 12 V | GND | A5 |
| B6 | 12 V | GND | A6 |

**Table 1.2**

| Parameter | Value | Unit |
|---|---|---|
| Rated voltage of each group of power pins | 29 | V |
| Rated current of each group of power pins | 1.1 | A |
| Rated temperature | -40° to 85° | C |
| Pin width | 0.3 | mm |
| Pin spacing | 0.6 | mm |

With reference to Table 1.1, Table 1.2, (A) in FIG. 7, and (B) in FIG. 7 together, on the gold finger connector before redefinition, the pin B1 to the pin B6 are defined as six positive pins, and the pin A1 to the pin A6 are defined as six ground pins that are in one-to-one correspondence with the six positive pins. The rated voltage of each group of power pins is 29 V, the rated current of each group of power pins is 1.1 A, and the rated temperature ranges from -40°C to -85°C. Although the rated voltage is 29 V, the gold finger connector in the memory module usually uses a working voltage of 12 V. To be specific, each group of power pins may receive a working voltage of 12 V and then supply the working voltage of 12 V to the memory module in which the power pins are located. Therefore, according to a parameter design of the power pin, the gold finger connector before redefinition has six groups of power pins in total, the rated current of each group of power pins is 1.1 A, and the working voltage of each group of power pins is 12 V. Therefore, maximum supply power that can be provided by the gold finger connector before redefinition is: 1.1 A×6×12 V=79.8 W.

Different from the gold finger connector before redefinition, the gold finger connector after redefinition may include less than six groups of power pins, and these power pins include at least one group of first power pins. Pin widths of a first positive pin and a first ground pin in the first power pins are both greater than pin widths of the positive pin and the ground pin in the original power pins, that is, greater than 0.3 mm. For example, refer to (C) in FIG. 7 and (D) in FIG. 7. In an example, the gold finger connector after redefinition may include only one group of large power pins (namely, first power pins). A positive pin (namely, a first positive pin) in the group of large power pins occupies an entire region in which the original pin B1 to the original pin B6 are located, and a ground pin (namely, a first ground pin) occupies an entire region in which the original pin A1 to the original pin A6 are located. Positions and input signals of the group of power pins may be shown in Table 2.1 below, and parameter information of the group of power pins may be shown in Table 2.2 below.

**Table 2.1**

| Pin | Signal | Signal | Pin |
|---|---|---|---|
| B1 | 12 V | GND | A1 |

**Table 2.2**

| Parameter | Value | Unit |
|---|---|---|
| Rated voltage of power pins | 29 | V |
| Rated current of power pins | 30 | A |
| Rated temperature | -40° to 85° | C |
| Pin width | 3.3 | mm |

Then, with reference to Table 2.1, Table 2.2, (C) in FIG. 7, and (D) in FIG. 7, on the gold finger connector that is after redefinition and that has only one group of power pins, any pin may be selected from the pin B1 to the pin B6 and defined as a positive pin, and any pin may be selected from the pin A1 to the pin A6 and defined as a ground pin. For example, in Table 2.1, the pin B1 is defined as the positive pin and the pin A1 is defined as the ground pin. When the original width of each pin is 0.3 mm and the pin spacing is 0.6 mm, the width of each pin after redefinition may be increased to 3.3 mm. In this way, although the working voltage is still 12 V, because the width of the pin is increased to 3.3 mm, in comparison with the original six power pins whose pin widths are 0.3 mm, an area of a conductive spring corresponding to the power pin after redefinition is nearly doubled. Testing shows that a through-current capability of the conductive spring of this area can be increased to at least 30 A. Therefore, maximum supply power that can be provided by the gold finger connector after redefinition can reach: 30 A×12 V=360 W, which is four times higher than 79 W before redefinition.

Because the supply power of the power pin is increased, increased supply power can support disposing more second storage media in the memory module. For example, currently, power consumption of each DDR is approximately 10 W to 15 W, and power consumption of another component and circuit in the memory module is approximately 20 W. If the gold finger connector before redefinition is used, because the maximum supply power of the power pin of the gold finger connector can only reach 79.8 W, other than 20 W provided for another component and circuit in the memory module, remaining 59.8 W of the supply power can be provided only for a maximum of four to six DDRs. In other words, a maximum of four to six DDRs can be encapsulated in each memory module. If the gold finger connector after redefinition is used, because the supply power of the power pin of the gold finger connector may reach 360 W, other than 20 W provided for another component and circuit in the memory module, remaining 340 W can be further provided for 22 to 34 DDRs. Therefore, 22 to 34 DDRs may be encapsulated in each memory module. This greatly expands a storage capacity of a server.

It should be noted that, after a quantity of DDRs increases, power of a memory controller also increases accordingly. Consequently, power of another component and circuit in the memory module also increases accordingly. Therefore, a quantity of DDRs that can be actually increased for expansion in the memory module is less than 22 to 34. It is found through experiment verification that, even if a memory controller with increased power is considered, the gold finger connector after redefinition can still support expansion using a specification of more than 10 DDRs, and memory expansion using this specification is sufficient for current use.

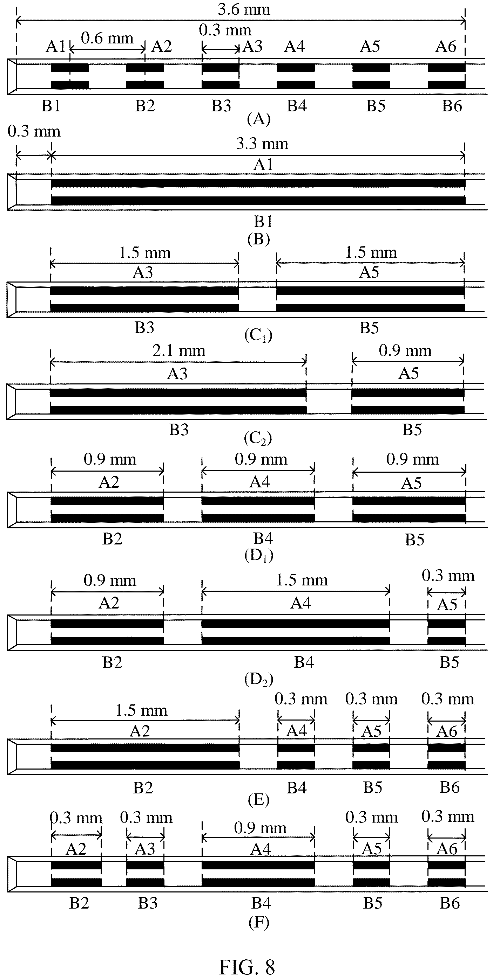

In addition, FIG. 7 provides descriptions only by using an example in which the gold finger connector after redefinition includes one group of power pins. However, in an actual product, the gold finger connector after redefinition may include any quantity of power pins from 1 to 5. For example, FIG. 8 is a diagram of several possible cases of power pins before and after redefinition according to this application.

(A) in FIG. 8 shows a structure of power pins before redefinition. A pin width of each pin in the structure is 0.3 mm, and a pin spacing between center points of two adjacent pins is 0.6 mm. Therefore, a region in which original pins B1 to B6 or original pins A1 to A6 are located occupies a total width of 3.6 mm. The structure of the power pins before redefinition defines six groups of power pins within a width range of 3.6 mm in which the original pins B1 to B6 or the original pins A1 to A6 are located, and a distance between edges of two adjacent pins is 0.3 mm.

(B), (C), (D), (E), and (F) in FIG. 8 show five structures of power pins after redefinition. The five structures of the power pins after redefinition respectively redefine one, two, three, four, and five groups of power pins in a width range of 3.6 mm in which original pins B1 to B6 or original pins A1 to A6 are located. In comparison with the structure of the power pins before redefinition shown in (A) in FIG. 8, at least one power pin whose pin width is greater than 0.3 mm exists in any structure of the power pins after redefinition. In addition, as a quantity of arranged power pins is increased, a pin width of the power pin is usually also decreased. For ease of understanding of this solution, the following separately describes in detail each structure of the power pins after redefinition.

In a possible redefinition solution, (B) in FIG. 8 shows a structure in which only one group of power pins exists after redefinition. The structure defines a pin A1 as a ground pin, and defines a pin B1 as a positive pin. The ground pin A1 occupies a region between a left edge shown in the figure of the original pin A1 and a right edge shown in the figure of the original pin A6, and the positive pin B1 occupies a region between a left edge shown in the figure of the original pin B1 and a right edge shown in the figure of the original pin B6. Other than maintained space of 0.3 mm between the pin and a left edge of a gold finger connector, remaining 3.3 mm may be all used to dispose a conductive spring of the pin. In other words, a width of a conductive spring corresponding to the ground pin A1 or the positive pin B1 after redefinition may be increased to 3.3 mm.

In another possible redefinition solution, (C₁) in FIG. 8 and (C₂) in FIG. 8 show two structures in which two groups of power pins exist after redefinition. The structure defines a pin A3 and a pin A5 as two ground pins, and defines a pin B3 and a pin B5 as two positive pins. Other than maintained space of 0.3 mm between the pin and a left edge of a gold finger connector and maintained space of 0.3 mm between edges of adjacent pins, remaining 3 mm may be all used to dispose conductive springs of the two ground pins or the two positive pins. For example, in the structure shown in (C₁) in FIG. 8, the conductive springs of the ground pins and the positive pins may have a same width. For example, the ground pin A3 occupies a region between a left edge shown in the figure of the original pin A1 and a right edge shown in the figure of the original pin A3, the ground pin A5 occupies a region between a left edge shown in the figure of the original pin A4 and a right edge shown in the figure of the original pin A6, the positive pin B3 occupies a region between a left edge shown in the figure of the original pin B1 and a right edge shown in the figure of the original pin B3, and the positive pin B5 occupies a region between a left edge shown in the figure of the original pin B4 and a right edge shown in the figure of the original pin B6. In this way, a width of a conductive spring corresponding to any positive pin or any ground pin may be increased to 1.5 mm. For another example, in the structure shown in (C₂) in FIG. 8, the ground pins or the positive pins may have different widths. For example, the ground pin A3 occupies a region between a left edge shown in the figure of the original pin A1 and a right edge shown in the figure of the original pin A4, the ground pin A5 occupies a region between a left edge shown in the figure of the original pin A5 and a right edge shown in the figure of the original pin A6, the positive pin B3 occupies a region between a left edge shown in the figure of the original pin B1 and a right edge shown in the figure of the original pin B4, and the positive pin B5 occupies a region between a left edge shown in the figure of the original pin B5 and a right edge shown in the figure of the original pin B6. In this way, widths of conductive springs corresponding to the ground pin A3 and the positive pin B3 may be increased to 2.1 mm, and widths of conductive springs corresponding to the ground pin A5 and the positive pin B5 may be increased to 0.9 mm.

In still another possible redefinition solution, (D₁) in FIG. 8 and (D₂) in FIG. 8 show two structures in which three groups of power pins exist after redefinition. The structure defines a pin A2, a pin A4, and a pin A5 as three ground pins, and defines a pin B2, a pin B4, and a pin B5 as three positive pins. Other than maintained space of 0.3 mm between the pin and a left edge of a gold finger connector and maintained space of 0.6 mm in total between edges of two groups of adjacent pins, remaining 2.7 mm may be all used to dispose conductive springs of the three ground pins or the three positive pins. For example, in the structure shown in (D₁) in FIG. 8, the conductive springs of the ground pins and the positive pins may have a same width. For example, the ground pin A2 occupies a region between a left edge shown in the figure of the original pin A1 and a right edge shown in the figure of the original pin A2, the ground pin A4 occupies a region between a left edge shown in the figure of the original pin A3 and a right edge shown in the figure of the original pin A4, the ground pin A5 occupies a region between a left edge shown in the figure of the original pin A5 and a right edge shown in the figure of the original pin A6, the positive pin B2 occupies a region between a left edge shown in the figure of the original pin B1 and a right edge shown in the figure of the original pin B2, the positive pin B4 occupies a region between a left edge shown in the figure of the original pin B3 and a right edge shown in the figure of the original pin B4, and the positive pin B5 occupies a region between a left edge shown in the figure of the original pin B5 and a right edge shown in the figure of the original pin B6. In this way, a width of a conductive spring corresponding to any positive pin or any ground pin may be increased to 0.9 mm. For another example, in the structure shown in (D₂) in FIG. 8, the ground pins or the positive pins may have different widths. For example, the ground pin A2 occupies a region between a left edge shown in the figure of the original pin A1 and a right edge shown in the figure of the original pin A2, the ground pin A4 occupies a region between a left edge shown in the figure of the original pin A3 and a right edge shown in the figure of the original pin A5, the ground pin A5 occupies a region of the original pin A6, the positive pin B2 occupies a region between a left edge shown in the figure of the original pin B1 and a right edge shown in the figure of the original pin B2, the positive pin B4 occupies a region between a left edge shown in the figure of the original pin B3 and a right edge shown in the figure of the original pin B5, and the positive pin B5 occupies a region of the original pin B6. In this way, widths of conductive springs corresponding to the ground pin A2 and the positive pin B2 may be increased to 0.9 mm, widths of conductive springs corresponding to the ground pin A4 and the positive pin B4 may be increased to 1.5 mm, and widths of conductive springs corresponding to the ground pin A5 and the positive pin B5 still remain 0.3 mm.

In yet another possible redefinition solution, (E) in FIG. 8 shows a structure in which four groups of power pins exist after redefinition. The structure defines a pin A2, a pin A4, a pin A5, and a pin A6 as ground pins, and defines a pin B2, a pin B4, a pin B5, and a pin B6 as positive pins. The ground pin A2 occupies a region between a left edge shown in the figure of the original pin A1 and a right edge shown in the figure of the original pin A3, the ground pin A4 occupies a region of the original pin A4, the ground pin A5 occupies a region of the original pin A5, the ground pin A6 occupies a region of the original pin A6, the positive pin B2 occupies a region between a left edge shown in the figure of the original pin B1 and a right edge shown in the figure of the original pin B3, the positive pin B4 occupies a region of the original pin B4, the positive pin B5 occupies a region of the original pin B5, and the positive pin B6 occupies a region of the original pin B6. In this way, widths of conductive springs corresponding to the ground pin A2 and the positive pin B2 may be increased to 1.5 mm, and widths of conductive springs corresponding to the ground pin A4, the ground pin A5, the ground pin A6, the positive pin B4, the positive pin B5, and the positive pin B6 still remain 0.3 mm.

In still another possible redefinition solution, (F) in FIG. 8 shows a structure in which five groups of power pins exist after redefinition. The structure defines a pin A2, a pin A3, a pin A4, a pin A5, and a pin A6 as ground pins, and defines a pin B2, a pin B3, a pin B4, a pin B5, and a pin B6 as positive pins. The ground pin A2 occupies a region of the original pin A1, the ground pin A3 occupies a region of the original pin A2, the ground pin A4 occupies a region between a left edge shown in the figure of the original pin A3 and a right edge shown in the figure of the original pin A4, the ground pin A5 occupies a region of the original pin A5, the ground pin A6 occupies a region of the original pin A6, the positive pin B2 occupies a region of the original pin B1, the positive pin B3 occupies a region of the original pin B2, the positive pin B4 occupies a region between a left edge shown in the figure of the original pin B3 and a right edge shown in the figure of the original pin B4, a positive pin B5 occupies a region of the original pin B5, and the positive pin B6 occupies a region of the original pin B6. In this way, widths of conductive springs corresponding to the ground pin A4 and the positive pin B4 may be increased to 0.9 mm, and widths of conductive springs corresponding to the ground pin A2, the ground pin A3, the ground pin A5, the ground pin A6, the positive pin B2, the positive pin B3, the positive pin B5, and the positive pin B6 still remain 0.3 mm.

It should be noted that FIG. 8 is merely an example of several types of pin arrangement. This example is described by using an example in which pins with same numbers are selected as the positive pins and the ground pins. However, in an actual product, a ground pin may be defined by selecting any one to five pins from the pin A1 to the pin A6, and a positive pin may be defined by selecting any one to five pins from the pin B1 to the pin B6. Numbers of a selected ground pin and a selected positive pin may be the same or may be different. For example, in another example, the pin A2 and the pin A5 may alternatively be selected as two ground pins, and the pin B2 and the pin B4 may also be selected as two positive pins. This is only a difference in pin numbers, provided that positions of the corresponding ground pins and positive pins are defined at same positions on a front side and a back side of a PCB.

In addition, the widths of the positive pins and the ground pins shown above are merely an example provided to ensure that the power pins can cover regions in which the original pins B1 to B6 and the original pins A1 to A6 are located to a maximum extent. However, in an actual scenario, all defined positive pins may cover only a part of regions in which the original pins B1 to B6 are located, and all defined ground pins may cover only a part of regions in which the original pins A1 to A6 are located. For example, (C₁) in FIG. 8 is used as an example. In another example, pin widths of the ground pin A3 and the positive pin B3 may alternatively be configured as 1 mm, and pin widths of the ground pin A5 and the positive pin B5 may alternatively be configured as 1.5 mm. Although such a configuration cannot completely cover an entire region in which the original pins B1 to B6 and the original pins A1 to A6 are located, a power supply capability of a power supply can also be increased because a width of a conductive spring is increased.

In addition, although any quantity of power pins in one to five groups of power pins may be redefined, considering that a smaller quantity of power pins may make it more difficult to plug or unplug the gold finger connector, to implement balance between flexible plugging and unplugging and high supply power, two or three large power pins may be redefined in the region in which the original power pins are located. In this way, the power supply capability is improved, and flexibility of plugging and unplugging the gold finger connector is also maintained.

It should be understood that the foregoing content provides descriptions only by using an example in which a pin width defined in an EDSFF standard is 0.3 mm. This is merely for ease of description of the solutions, and the pin width is not limited to the value. With evolution of the EDSFF standard, the pin width may also change to another value. Alternatively, when the EDSFF standard is applied to another field, a complied standard may alternatively specify that the pin width is another value. Alternatively, the pin width cannot be strictly limited to 0.3 mm due to a process manufacturing error, but fluctuates around 0.3 mm. However, any power pin that implements higher supply power according to a pin combination solution provided in this application falls within the protection scope of this application.

In addition, the foregoing uses only a memory expansion scenario as an example to describe how to obtain a larger power supply capability through power pin redefinition, so as to implement memory expansion using a large specification. This solution may be further applied to any other scenario in which a high-power module is needed, for example, an accelerator card or a GPU card. Power pins of a gold finger connector in the accelerator card or GPU card are redefined, to provide higher supply power for the accelerator card and GPU card, and support disposing more accelerator cards or GPU cards. A scenario to which the solution of redefining the power pins of the gold finger connector is applicable is not limited in this application.

In addition, because the power pins of the gold finger connector are redefined, a power connector plugged to the gold finger connector also needs to be correspondingly adjusted. For example, when the gold finger connector is redefined as having two groups of power pins (input pins), the power connector may also be redefined as having two groups of power pins (output pins). Alternatively, even if the power connector is not redefined, and a design of original six groups of power pins is still used, according to the redefinition solution provided in this application, after the two are plugged, the original six groups of power pins in the power connector can still contact power pins on a gold finger connector after redefinition, so that the gold finger connector after redefinition can still be compatible with the original power connector. Alternatively, even if the gold finger connector is not redefined, and power pins of the power connector are redefined in this manner, the gold finger connector can also be compatible with a power connector after redefinition. It can be learned that in this power pin redefinition solution, the gold finger connector can be adapted to the original power connector or the power connector after redefinition, and compatibility and adaptability of the gold finger connector are good.

In another possible embodiment, this application further provides a gold finger connector having a newly added out-of-band communication pin. In comparison with a gold finger connector before redefinition, the gold finger connector may implement communication between a processing module in a memory module and a media management board outside the memory module through the newly added out-of-band communication pin. For example, the architecture shown in FIG. 5b is used as an example. The newly added out-of-band communication pin may be configured to implement communication between the second integrated unit in the memory module and the third integrated unit 421 in the media management board 420 outside the memory module, to provide hardware support for the second integrated unit in the memory module to transmit access frequency information to the third integrated unit 421 outside the memory module, so as to implement a cold and hot migration solution that is based on the second integrated unit.

Specifically, still refer to (A) in FIG. 7 and (C) in FIG. 7. In comparison with the gold finger connector before redefinition, one group of out-of-band communication pins is newly added to a gold finger connector after redefinition, and the group of out-of-band communication pins may be connected to the second integrated unit in the memory module through the out-of-band communication bus. In this way, after the memory module is plugged to the media management board 420 through the gold finger connector, the out-of-band communication bus may implement a connection between the second integrated unit and the gold finger connector, so as to implement a connection between the second integrated unit and the third integrated unit 421 in the media management board 420. In this way, the second integrated unit may send access frequency information of each second storage address in the memory module to the third integrated unit 421 through the out-of-band communication bus and the out-of-band communication pin on the gold finger connector. The out-of-band communication pin may be defined by selecting a reserved pin on the gold finger connector, for example, a pin B68, a pin B69, a pin A68, a pin A69, a pin A70, and a pin S2 in the EDSFF specification.

In some scenarios, the out-of-band communication pin may perform transmission of the access frequency information by using a differential signal. In this case, according to the EDSFF specification, an example of a position of the out-of-band communication pin and an input signal may be configured as shown in Table 3 below.

**Table 3**

| Pin | Signal | Signal | Pin |
|---|---|---|---|
| B68 | Hisport_TXn | Hisport_RXn | A68 |
| B69 | Hisport_TXp | Hisport_RXp | A69 |

With reference to Table 3 and (C) in FIG. 7 together, on the gold finger connector after redefinition, the reserved pin B68 and the reserved pin B69 may be defined as two transmit pins of the differential signal, the reserved pin A68 and the reserved pin A69 may be defined as two receive pins of the differential signal, and conductive springs corresponding to the four pins may be pasted at idle positions on a right edge of the PCB, to implement corresponding out-of-band communication functions. In this way, the second integrated unit may send, through the defined pin B68 and the defined pin B69, the access frequency information of each second storage address in the memory module in which the second integrated unit is located to the third integrated unit 421, and may receive, through the defined pin A68 and pin A69, returned information of the third integrated unit 421, for example, response information indicating successful receiving.

In some examples, a pin width of each transmit pin or each receive pin and a pin spacing between adjacent transmit pins or adjacent receive pins may remain the same as configurations of the gold finger connector before redefinition. For example, the pin width of each transmit pin and each receive pin is configured as 0.3 mm, and the pin spacing between two adjacent transmit pins or two adjacent receive pins is configured as 0.6 mm. However, this is only an optional implementation. In another optional implementation, a pin width of one or more transmit pins, a pin width of one or more receive pins, a pin spacing between one or more groups of adjacent transmit pins, or a pin spacing between one or more groups of adjacent receive pins may remain different from a configuration of the gold finger connector before redefinition. This is not specifically limited.

It should be understood that the positions of the transmit pins, the receive pins, and the conductive springs shown in the foregoing content are merely an example. In another scenario, another reserved pin may be selected as the transmit pin or the receive pin, or the conductive spring may be encapsulated at another position of the PCB. This is not specifically limited.

Based on the foregoing two differences, the following describes definitions of the pins on the gold finger connector after redefinition based on Table 4 by using an example in which two groups of power pins are redefined. It should be noted that, in this example, an example in which the gold finger connector complies with the EDSFF standard is used. However, it should be understood that a same design concept may also be applicable to any existing information security standard or any information security standard that may evolve in the future. For example, the standard may be common criteria of information technical security evaluation methodology (common criteria of information technical security evaluation methodology, CEM), a technical specification standard OCP, or another similar standard. This is not specifically limited in this application.

**Table 4**

| Pin | Signal | Signal | Pin |
|---|---|---|---|
| B1 | 12 V | GND | A2 |
| B5 | 12 V | GND | A4 |
| B7 | MFG | SMBCLK | A7 |
| B8 | RFU | ASMBDAT8 | A8 |
| B9 | DUALPORTEN# | SMARST# | A9 |
| B10 | PERST0# | LED | A10 |
| B11 | 3.3Vaux | PERST1#/CLKREQ# | A11 |
| B12 | PWRDIS | PRSNT0# | A12 |
| B13 | GND | GND | A13 |
| B14 | REFCLKn0 | REFCLKn1 | A14 |
| B15 | REFCLKp0 | REFCLKp0 | A15 |
| B16 | GND | GND | A16 |
| B17 | PETn0 | PERn0 | A17 |
| B18 | PETp0 | PERp0 | A18 |
| B19 | GND | GND | A19 |
| B20 | PETn1 | PERn1 | A20 |
| B21 | PETp1 | PERp1 | A21 |
| B22 | GND | GND | A22 |
| B23 | PETn2 | PERn2 | A23 |
| B24 | PETp2 | PERp2 | A24 |
| B25 | GND | GND | A25 |
| B26 | PETn3 | PERn3 | A26 |
| B27 | PETp3 | PERp3 | A27 |
| B28 | GND | GND | A28 |
| B29 | GND | GND | A29 |
| B30 | PETn4 | PERn4 | A30 |
| B31 | PETp4 | PERp4 | A31 |
| B32 | GND | GND | A32 |
| B33 | PETn5 | PERn5 | A33 |
| B34 | PETp5 | PERp5 | A34 |
| B35 | GND | GND | A35 |
| B36 | PETn6 | PERn6 | A36 |
| B37 | PETp6 | PERp6 | A37 |
| B38 | GND | GND | A38 |
| B39 | PETn7 | PERn7 | A39 |
| B40 | PETp7 | PERp7 | A40 |
| B41 | GND | GND | A41 |
| B42 | PRSNT1# | DFU | A42 |
| B43 | GND | GND | A43 |
| B44 | PETn8 | PERn8 | A44 |
| B45 | PETp8 | PERp8 | A45 |
| B46 | GND | GND | A46 |
| B47 | PETn9 | PERn9 | A47 |
| B48 | PETp9 | PERp9 | A48 |
| B49 | GND | GND | A49 |
| B50 | PETn10 | PERn10 | A50 |
| B51 | PETp10 | PERp10 | A51 |
| B52 | GND | GND | A52 |
| B53 | PETn11 | PERn11 | A53 |
| B54 | PETp 11 | PERp 11 | A54 |
| B55 | GND | GND | A55 |
| B56 | PETn12 | PERn12 | A56 |
| B57 | PETp12 | PERp12 | A57 |
| B58 | GND | GND | A58 |
| B59 | PETn13 | PERn13 | A59 |
| B60 | PETp 13 | PERp13 | A60 |
| B61 | GND | GND | A61 |
| B62 | PETn14 | PERn14 | A62 |
| B63 | PETp14 | PERp14 | A63 |
| B64 | GND | GND | A64 |
| B65 | PETn15 | PERn15 | A65 |
| B66 | PETp15 | PERp15 | A66 |
| B67 | GND | GND | A67 |
| B68 | Hisport_TXn | Hisport_RXn | A68 |
| B69 | Hisport_TXp | Hisport_RXp | A69 |
| B70 | PRSNT1# | DFU | A70 |

Refer to Table 4. In comparison with the gold finger connector before redefinition, pin definitions of the pins B7 to B67, the pin B70, the pins A7 to A67, and the pin A70 on the gold finger connector after redefinition remain unchanged, the pin B1 and the pin B5 are defined as two positive pins, the pin A2 and the pin A4 are defined as two ground pins, the original reserved pins B67 and B68 are defined as two transmit pins of the differential signal, and the original reserved pins A67 and A68 are defined as two receive pins of the differential signal. In addition, although pins B2 to B4, a pin B6, a pin A1, a pin A3, a pin A5, and a pin A6 are not further defined, regions in which these pins are located are occupied by large power pins after redefinition. Therefore, these pins do not exist.

In this application, the pins on the gold finger connector are redefined by using the foregoing two differences, so that a power supply capability of the gold finger connector can be improved, more second storage media can be disposed in the memory module, and the gold finger connector after redefinition can further adapt to an updated memory module, and more specifically, adapt to a receiving and sending capability of the second integrated unit newly added to the memory module, to provide support for implementing the following cold and hot data migration solution.

It should be noted that the foregoing content is merely an example of a possible redefinition manner. Specific pins selected as the power pins or the out-of-band communication pins may be set by a person skilled in the art based on a requirement or a habit. This is not specifically limited in this application.

In addition, in this application, the conductive spring may be made of any material having a conductive function, for example, gold-plated copper, beryllium copper, manganese steel, phosphor bronze, brass, iron, or stainless steel. A shape of the conductive spring may be designed based on an actual product requirement, for example, may be set to a rectangle shown in FIG. 7, or may be set to a bent shape. In addition to implementing the conductive function, the conductive spring of the bent shape can also be in contact with a connector on a peer side through a bent end, so that two connected components are closer and are not easily dislocated, to maintain reliability of a connection between the two components.

In addition, with development of mechanical manufacturing technologies, more materials and forms may be developed for the conductive spring. However, any solution in which a larger power pin is obtained by combining the original power pins, or any solution in which cold and hot migration based on the second integrated unit is implemented by adding the out-of-band communication pin falls within the protection scope of this application. This is not limited in this application.

The foregoing content describes a specific difference between the gold finger connector in the memory module provided in this application and a gold finger connector in an existing memory module. In addition, this application further provides a solution of performing cold and hot migration on data of a server. The following describes specific implementations of the cold and hot migration solution.

For ease of description of the solution, in the following, each storage address corresponding to a first storage medium is referred to as each first storage address, and each storage address corresponding to a second storage medium is referred to as each second storage address. However, it should be understood that this does not constitute a limitation on this application.

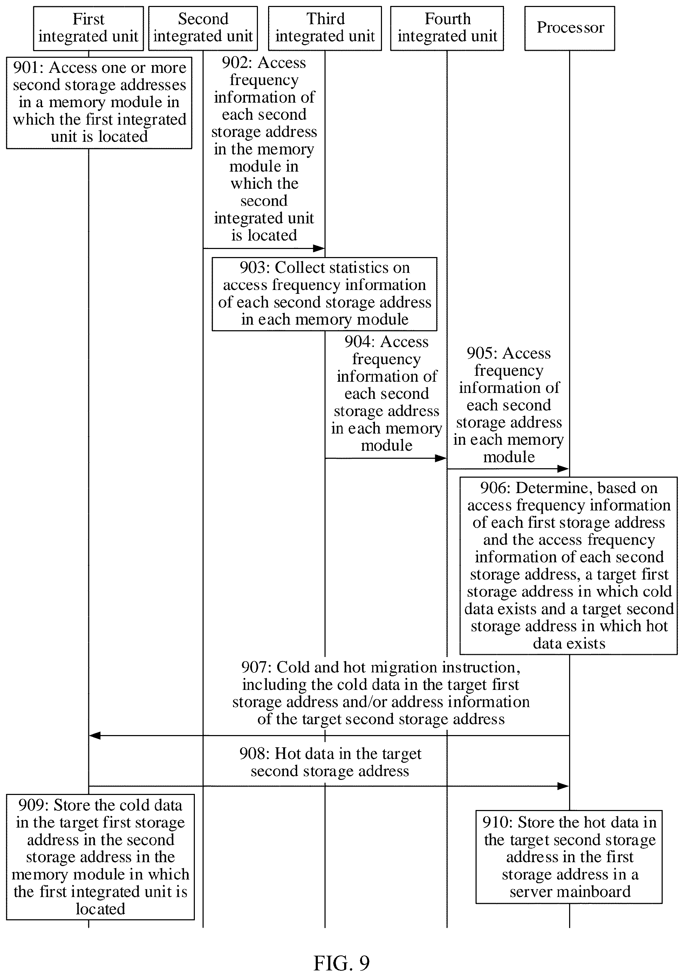

For example, a server architecture shown in FIG. 5b is used as an example. FIG. 9 is a schematic flowchart of interaction of a cold and hot data migration solution according to this application. As shown in FIG. 9, a cold and hot data migration procedure includes the following steps.

Step 901: A first integrated unit accesses one or more second storage addresses in a memory module in which the first integrated unit is located.

For example, for each memory module, a first integrated unit in the memory module may be connected, through a control address line, to all memory cells included in each first storage medium in the memory module. When a processor 411 needs to read/write data in a specific memory module, the processor 411 may send a read/write request to a first integrated unit in the memory module. The first integrated unit determines, based on the read/write request, a memory cell that needs to be accessed this time, then enables, by adjusting a high/low level of a control address line, the memory cell that needs to be accessed, and then stores data in the memory cell, or reads data in the memory cell. There may be one, a plurality of, or all memory cells that need to be accessed. This is not specifically limited.

Step 902: A second integrated unit sends access frequency information of each second storage address in the memory module in which the second integrated unit is located to a third integrated unit.

For example, a second integrated unit in any memory module may monitor, in a periodic manner, each control address line disposed in the memory module. If a level jump occurs in a specific control address line in a periodicity time period of each periodicity, the second integrated unit may determine a memory cell accessed this time based on a status of the jump, determine a second storage address to which the memory cell accessed this time belongs, and further update access frequency of the second storage address. Then, when the periodicity time period of each periodicity ends, the second integrated unit may send access frequency of each second storage address in the memory module in which the second integrated unit is located to the third integrated unit. Specifically, the access frequency may be sent to the third integrated unit through an out-of-band communication bus additionally added to the memory module and an out-of-band communication pin newly added to the gold finger connector.

For example, statistics on the access frequency of each second storage address in the memory module may be collected in a second access frequency table. The second access frequency table may be stored locally in the second integrated unit, or may be stored outside the second integrated unit, for example, in the first integrated unit or a second storage medium. The second access frequency table may include each second storage address in the memory module and the corresponding access frequency, and a refresh operation may be performed based on preset periodicity duration, for example, once every two seconds. Each second storage address may include only an address of one memory cell, or may include addresses of a plurality of memory cells. For example, when second storage address assignment is performed based on space of one memory cell, a quantity of memory cells included in the memory module is also a quantity of second storage addresses included in the memory module. When second storage address assignment is performed based on space of more than one memory cell, a quantity of second storage addresses included in the memory module is less than a quantity of memory cells, and quantities of memory cells corresponding to different second storage addresses may be the same or may be different. This is not specifically limited.

For example, in a specific example, Table 5.1 shows a second access frequency table obtained through assignment of second storage addresses in a memory module 431 based on space of more than one memory cell.

**Table 5.1**

| Second access frequency table corresponding to a memory module 431 | |
|---|---|
| Storage address | Access frequency |
| 0x0000 to 0x0005 | 10 |
| 0x0006 | 5 |
| 0x0007 to 0x000D | 0 |
| 0x000E to 0x0010 | 15 |

As shown in Table 5.1, the memory module 431 has 17 memory cells in total. 1^{st} to 6^{th} memory cells are assigned as a 1^{st} second storage address, that is, 0x0000 to 0x0005, and the second storage address has been accessed for 10 times so far. A 7^{th} memory cell is assigned as a 2^{nd} second storage address, that is, 0x0006, and the second storage address has been accessed for five times so far. 8^{th} to 14^{th} memory cells are assigned as a 3^{rd} second storage address, that is, 0x0007 to 0x000D, and the second storage address has not been not accessed so far. 15^{th} to 17^{th} memory cells are assigned as a 4^{th} second storage address, that is, 0x000E to 0x0010, and the second storage address has been accessed for 15 times so far.

It is assumed that at a specific moment of a current periodicity, a second integrated unit 43112 determines, based on a level jump status of a control address line in the memory module 431, that memory cells accessed this time are the 7^{th} to 10^{th} memory cells. In this case, the second integrated unit 43112 may update the second access frequency table to Table 5.2 below.

**Table 5.2**

| Second access frequency table corresponding to a memory module 431 | |
|---|---|
| Storage address | Access frequency |
| 0x0000 to 0x0005 | 10 |
| 0x0006 | 6 |
| 0x0007 to 0x000D | 1 |
| 0x000E to 0x0010 | 15 |

Refer to Table 5.1 and Table 5.2 together. Because the 7^{th} memory cell is accessed, a quantity of access times of the second storage address 0x0006 corresponding to the 7^{th} memory cell is increased by 1, and is updated to 6 times. Because the 8^{th} to 10^{th} memory cells are accessed, a quantity of access times of the second storage address 0x0007 to 0x000D corresponding to the 8^{th} to 10^{th} memory cells is also increased by 1, and is updated to 1 time.

It should be clarified that the foregoing content provides descriptions only by using an example in which the table carries access frequency of each second storage medium unit. This application is not limited to that the access frequency can be carried only in the table. For example, in another example, the access frequency may alternatively be carried in another manner such as an access frequency bar chart, an access frequency line chart, a stack, or a queue. This is not specifically limited.

Step 903: The third integrated unit collects statistics to obtain access frequency information of each second storage address in each memory module.

For example, a second integrated unit in each memory module may send, to a third integrated unit 421 based on the same periodicity, a second access frequency table of the memory module in which the second integrated unit is located. After receiving the second access frequency table of each memory module, the third integrated unit 421 obtains a large second access frequency table through combination. In this way, the large second access frequency table may include access frequency of all second storage addresses in each memory module in a same time period. Because there is a same time standard, comparability of the second access frequency table is good.

Step 904: The third integrated unit sends access frequency information of each second storage address in each memory module to a fourth integrated unit.

For example, the third integrated unit 421 may send the large second access frequency table to a fourth integrated unit 422 through a local bus between the third integrated unit 421 and the fourth integrated unit 422.

Step 905: The fourth integrated unit sends the access frequency information of each second storage address in each memory module to the processor.

For example, a media management board 420 and a server mainboard 410 may be connected through an external bus. After receiving the large second access frequency table from the third integrated unit 421, the fourth integrated unit 422 may send the second access frequency table to the processor 411 through the external bus. The external bus may be, for example, a USB or a PCIe.

Step 906: The processor determines, based on access frequency information of each first storage address and the access frequency information of each second storage address, a target first storage address in which cold data exists and a target second storage address in which hot data exists.

For example, the processor 411 may also monitor, based on the same periodicity as the second integrated unit, access frequency of each first storage address directly connected to the processor 411. For example, a first access frequency table may be disposed in the processor 411. The first access frequency table includes access frequency of each first storage address in the server mainboard 410 in the current periodicity. After receiving the second access frequency table from the fourth integrated unit 422, the processor 411 may obtain the access frequency of all second storage addresses in all memory modules through interpretation, then determine, based on the access frequency of all second storage addresses, second storage addresses having high access frequency (for example, the access frequency is greater than a hotness threshold), and determine these second storage addresses as target second storage addresses in which the hot data exists. In addition, the processor may further determine, based on access frequency of all first storage addresses, first storage addresses having low access frequency (for example, the access frequency is less than a coldness threshold), and determine these first storage addresses as target first storage addresses in which the cold data exists. The hotness threshold is greater than the coldness threshold. For example, in some scenarios, the hotness threshold may be set to 10, and the coldness threshold may be set to 2.

Step 907: The processor sends a cold and hot migration instruction to the first integrated unit, where the cold and hot migration instruction includes the cold data in the target first storage address and/or address information of the target second storage address.

Herein, the address information of the target second storage address may be, for example, a physical address of the target second storage address.

For example, after determining the target first storage address in which the cold data exists, the processor 411 may first read, by using a memory controller integrated into the processor 411, the cold data stored in the target first storage address, then generate one or more cold and hot migration instructions with reference to a data amount of the read cold data and a memory module in which the target second storage address in which the hot data exists is located by using the read cold data and/or the address information of the target second storage address in which the hot data exists, and then send the one or more cold and hot migration instructions to a first integrated unit in one or more memory modules. Any cold and hot migration instruction may include only the cold data, may include only the address information of the target second storage address in which the hot data exists, or may include both the cold data and the address information of the target second storage address in which the hot data exists.

For example, when the target second storage address in which the hot data exists does not exist, but the target first storage address in which the cold data exists exists, the processor 411 may generate the one or more cold and hot migration instructions based on the cold data in the target first storage address. For example, if the data amount of the cold data is small, the processor 411 may directly generate the cold and hot migration instruction based on all cold data, and send the cold and hot migration instruction to a first integrated unit in a memory module that has smallest occupation, to migrate cold data in the server mainboard 410 to an available memory module as soon as possible, and release occupied space of the server mainboard 410. On the contrary, if the data amount of the cold data is large, the processor 411 may generate a plurality of cold and hot migration instructions by splitting the cold data, and send the plurality of cold and hot migration instructions to first integrated units in a plurality of memory modules that have small occupation, to implement balance of memory module occupation while migrating cold data in the server mainboard 410 to an available memory module.

For another example, when the target first storage address in which the cold data exists does not exist, but the target second storage address in which the hot data exists exists, the processor 411 may add, based on a memory module to which the target second storage address belongs, a physical address of a target second storage address included in each memory module to a corresponding cold and hot migration instruction, and send the cold and hot migration instruction to the memory module, so that each memory module specifically returns local hot data in the memory module to the processor 411.

For another example, when the target first storage address in which the cold data exists exists, and the target second storage address in which the hot data exists also exist, the processor 411 may select, based on an occupation status of each memory module, several memory modules that currently have small occupation, and use these memory modules and a memory module in which the hot data exists as candidate memory modules. Then, for a candidate memory module in which the target second storage address does not exist in these candidate memory modules, the processor may generate a corresponding cold and hot migration instruction based only on a part of cold data, and send the cold and hot migration instruction to a first integrated unit in the candidate memory module, to evenly store cold data in the server mainboard 410 by using a large amount of available space in the candidate memory module. For a candidate memory module in which the target second storage address exists in these candidate memory modules, the processor may generate a corresponding cold and hot migration instruction based on the target second storage address or the target second storage address and a part of cold data, and send the cold and hot migration instruction to a first integrated unit in the candidate memory module, so that when the candidate memory module is indicated to return included hot data, available space in the candidate memory module is further used to store the cold data in the server mainboard 410. Certainly, the second storage address and the cold data are carried in one cold and hot migration instruction and sent to the first integrated unit. This is only an optional implementation. In another implementation, different cold and hot migration instructions may be generated based on the second storage address and the cold data, and sent to a same first integrated unit. This is not specifically limited in this application.

Step 908: The first integrated unit sends the hot data in the target second storage address to the processor based on the address information of the target second storage address carried in the cold and hot migration instruction.

For example, the first integrated unit may read the hot data in the target second storage address by using a locally integrated memory controller, and then send the hot data to the processor 411 through a serial bus. The serial bus supports memory semantics, and may implement transmission of memory data and a control signal of the memory data through a protocol of the serial bus that supports the memory semantics.

Further, for example, the cold and hot migration instruction carries the physical address of the target second storage address, and the first integrated unit may directly access the physical address, to obtain the hot data stored in the target second storage address. Physical addresses of the target second storage addresses may be consecutive, or may be inconsecutive. This is not specifically limited.

Step 909: The first integrated unit stores the cold data in the target first storage address carried in the cold and hot migration instruction in the second storage address in the memory module in which the first integrated unit is located.

Herein, the first integrated unit may store the cold data in the target first storage address in the target second storage address, may store the cold data in another idle second storage address, or may store a part of the cold data in the target second storage address and a part of the cold data in another idle second storage address. This is not specifically limited.

Step 910: The processor stores the hot data in the target second storage address in the first storage address in the server mainboard.

Further, for example, after receiving the hot data in the target second storage address sent by any first integrated unit, the processor 411 may store the hot data in the target first storage address, may store the hot data in another idle first storage address, or may store a part of the hot data in the target first storage address and a part of the hot data in another idle first storage address. This is not specifically limited.

In the foregoing cold and hot migration solution, a delay of access of the processor to the first storage medium in the server mainboard is less than a delay of access of the processor to the second storage medium in the memory module. Therefore, the hot data in the memory module is migrated to the server mainboard, so that the processor can access data with high heat more quickly, and data access performance can be improved. The cold data in the server mainboard is migrated to the memory module, so that occupation of the cold data in the server mainboard can also be released, and a storage capacity of the hot data can be increased. Memory performance of a server can be improved by improving an access speed of the hot data and increasing the storage capacity of the hot data.

It may be understood that the foregoing describes the cold and hot data migration method only by using the server architecture shown in FIG. 5b as an example. In another example, when the server uses the architecture shown in FIG. 5a, a processing module in the memory module includes only one integrated unit. The integrated unit may be connected between a gold finger connector in the memory module in which the integrated unit is located and at least one second storage medium in the memory module in which the integrated unit is located, and may be configured to implement all functions of the first integrated unit and the second integrated unit in the method embodiment shown in FIG. 9, including step 901, step 902, step 907, step 908, and step 909 in FIG. 9. For example, the integrated unit may receive the read/write request from the media management board 420 through the gold finger connector in the memory module in which the integrated unit is located, and may access, based on the read/write request, the at least one second storage medium in the memory module in which the integrated unit is located, and then send, through the gold finger connector to the media management board 420, access frequency information, within a preset time period, of each second storage address corresponding to the at least one second storage medium in the memory module in which the integrated unit is located, so that the media management board 420 sends the access frequency information to the processor 411 in the server mainboard 410, and the processor 411 determines the target first storage address in which the cold data exists and the target second storage address in which the hot data exists. The integrated unit may further receive the cold and hot migration instruction from the processor 411 through the gold finger connector in the memory module in which the integrated unit is located. The cold and hot migration instruction carries cold data in a first storage address (namely, the target first storage address) associated with the processor and/or address information of a second storage address (namely, the target second storage address) associated with the memory module. The integrated unit may send the hot data in the target second storage address to the processor 411 through the gold finger connector according to the cold and hot migration instruction, and may store the cold data in the target first storage address in the second storage address in the memory module 431 in which the integrated unit is located, to implement a migration operation of the cold data and the hot data.

Alternatively, in still another example, a processing module in any memory module may be divided into three or more integrated units, each integrated unit shares some functions of the processing module, and the three or more integrated units jointly implement all functions of the processing module.

Similarly, in another example, when the server uses the architecture shown in FIG. 5a, the media management board 421 includes only one integrated unit. The integrated unit may be connected between a gold finger connector in any memory module and the processor 411 in the server mainboard 410, and is configured to implement all functions of the third integrated unit 421 and the fourth integrated unit 422 in the method embodiment shown in FIG. 9, including step 903, step 904, and step 905 in FIG. 9. For example, the integrated unit may receive, through the gold finger connector, access frequency information that is sent by the processing module in any memory module and that is of each second storage address in the memory module in which processing module is located, and may collect statistics on access frequency information of each second storage address in each memory module, and then send statistics information to the processor 411, to assist the processor 411 and the memory module in implementing the foregoing cold and hot migration solution.

Alternatively, in still another example, the media management board 420 may include three or more integrated units. Each integrated unit shares some functions of the media management board 420, and the three or more integrated units jointly implement all functions of the media management board 420.

It should be noted that, for concepts, explanations, detailed descriptions, and other steps related to the cold and hot migration solution in this part of content, refer to descriptions about the content in the method embodiment shown in FIG. 9. Details are not described herein again.

It may be understood that, in the foregoing solutions, the processing module in the memory module and the media management board outside the memory module jointly implement the migration operation of the cold data and hot data. The processing module in the memory module may be configured to send only access frequency information of a storage medium in the memory module to a component outside the module, and a specific memory migration operation is performed on a component side outside the module. Therefore, if the processing module includes only one integrated unit, even if the integrated unit is obtained by improving an ASIC in an existing memory module, the integrated unit may only add an information sending function on a basis of an original memory access function of the ASIC. In comparison with a solution in which an ASIC needs to be re-developed for an existing new server system to implement a memory migration function as a whole, development difficulty is lower, and lower additional development costs and labor costs can be introduced on a basis of implementing the cold and hot migration solution, to further implement low-cost memory expansion of the server. If the processing module includes at least two integrated units, one of the integrated units (for example, the first integrated unit) may remain as an original ASIC. One or two new integrated units (for example, the second integrated units) are additionally added to the memory module, frequently accessed data in the second storage medium in the memory module in which the one or two new integrated units are located may be migrated to the first storage medium in the server mainboard through the one or two new integrated units jointly with the component outside the module, and there is no need to re-develop an original integrated unit in the memory module. In comparison with re-developing the original integrated unit, an operation of developing one or two new integrated units has a simpler research and development process. For example, neither how to arrange components corresponding to different functions on one unit nor how to route cables to enhance anti-interference between different functional components needs to be considered, and labor costs and research and development costs needed are lower. It can be learned that, regardless of a quantity of integrated units included in the processing module, the cold and hot migration solution is implemented by using the server system provided in this application, so that the memory performance of the server can be improved, and additional costs can be introduced as low as possible, without increasing working pressure of the original integrated unit in the memory module. This helps implement a design concept of cost reduction in a process of expanding a server memory.

The foregoing content describes specific implementations of the cold and hot migration solution from a perspective of node interaction of an entire server system. The following describes, from a perspective of internal implementation of the memory module, work and some other functions that are borne by each component in the memory module when the cold and hot migration solution is implemented.

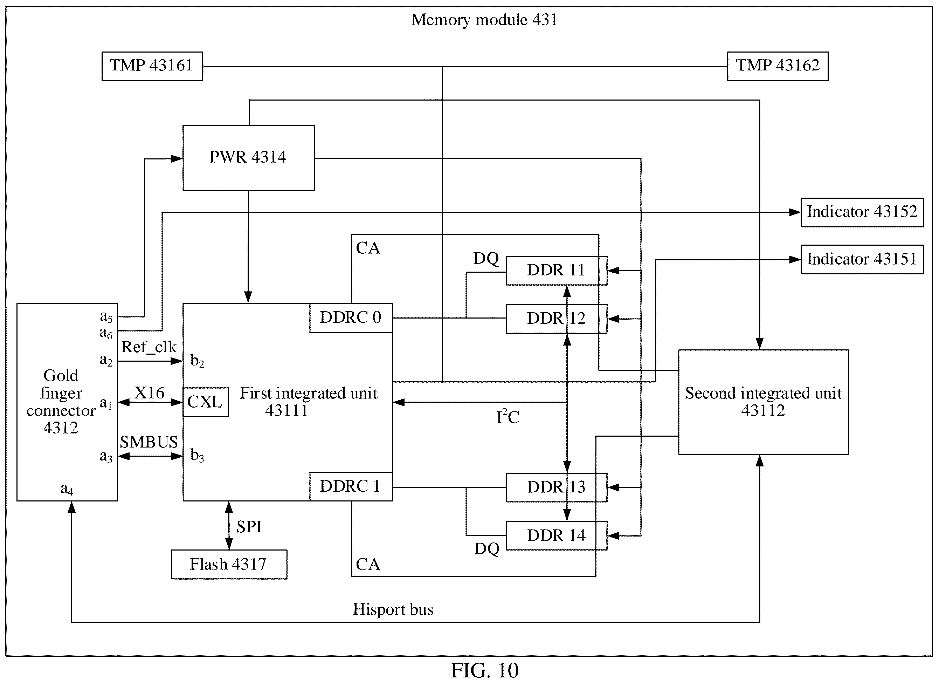

The system architecture shown in FIG. 5b is used as an example. FIG. 10 is a diagram of an internal circuit of a memory module according to this application. A memory module 431 is used as an example in the figure. As shown in FIG. 10, in addition to including a first integrated unit 43111, a second integrated unit 43112, at least one second storage medium (for example, a DDR 11 to a DDR 14), and a gold finger connector 4312, the memory module 431 may further include a power module (power, PWR) 4314, at least one indicator (for example, a read/write status indicator 43151 and a memory module indicator 43152), at least one temperature transducer (temperature transducer, TMP) (for example, a TMP 43161 and a TMP 43162), a flash memory (flash memory, FLASH) 4317, and data lines, control address lines, and other communication lines that implement connection relationships shown in the figure. In addition, a PCB may be further included. Components in the memory module 431 are arranged at corresponding positions of the PCB, and two interconnected components may be connected through intra-board cabling on the PCB.

It should be noted that, only a board arrangement relationship of the memory module 431 is shown herein, and a multi-board arrangement may alternatively be configured in some scenarios. For example, the memory module 431 includes a plurality of PCBs that overlap each other, and the components in the memory module 431 are separately arranged on the plurality of PCBs. Components arranged on one PCB are connected through intra-board cabling, and components arranged on different PCBs are connected through inter-board cabling. Overlapping of the plurality of PCBs may be complete overlapping, may be partial overlapping, or may be partial overlapping of a part of PCBs and complete overlapping of a part of PCBs. In this way, overlapping arrangement is performed in space, so that an occupied area of the memory module can be reduced, and a miniaturization design of the memory module can be implemented.

In addition, component composition of the memory module shown in FIG. 10 is merely an example, and the memory module may alternatively include more or fewer components than those shown in the figure. For example, in some embodiments, the memory module 431 may further include an integrated unit other than the first integrated unit 43111 and the second integrated unit 43112, and the another integrated unit is configured to share work of the first integrated unit 43111 or the second integrated unit 43112. For another example, in some other embodiments, a DDRC may alternatively not be integrated into the first integrated unit 43111, for example, may be used as an independent device, may be integrated into the second integrated unit 43112, or may be integrated into another non-integrated unit. For still another example, in still some other embodiments, the memory module 431 may alternatively not include the PWR 4314, but may be directly powered by using an external power supply, to save an occupied volume of the memory module 431. For still another example, in still some other embodiments, the memory module 431 may alternatively include more than or less than two indicators, or include more than or less than two TMPs. There are still many possible implementations, which are not listed one by one in this application.

The following describes each component in the memory module in detail by using the component composition shown in FIG. 10 as an example.

The first integrated unit 43111 includes a high-speed serial protocol (compute express link, CXL) interface and at least one DDR controller (DDR controller, DDRC). A CXL may be connected to a serial pin a₁ on the gold finger connector 4312 through a serial bus. The serial bus may be, for example, an X16 bus of 16 serial transmission channels shown in the figure, or may be an X4 bus or an X8 bus. This is not limited. In addition, a quantity of DDRCs depends on a memory mode and a quantity of DDRs in the memory module 431. For example, when a 2DPC mode is used, one DDRC may be connected to two DDRs. Because the memory module 431 includes four DDRs, the first integrated unit 43111 may include two DDRCs, for example, a DDRC 0 and a DDRC 1. The DDRC 0 is connected to the DDR 11 and the DDR 12 through the data line, and the DDR 1 is connected to the DDR 13 and the DDR 14 through the data line. The data line may be configured to perform transmission of a data signal, for example, a DQ signal. In a data read scenario, the DDRC may determine when to receive read data based on a DQ signal sent by the connected DDR. In a data write scenario, the DDR may determine when to trigger data receiving based on a DQ signal sent by the connected DDRC. For example, in some scenarios, data reading and writing depend on the DQ signal and a data strobe signal DQS. The DQS signal is transmitted on a DQS signal line, and each chip has a DQS data line (not shown in the figure), configured to transmit the DQS signal used for reading and writing reference. The DQS signal can be received by the DDRC and the DDR in real time. In the data read scenario, after receiving the DQ signal of the DDR, the DDRC may compare the DQ signal with the DQS signal. When an edge of the DQ signal is aligned with an edge of the DQS signal (for example, a rising edge of the DQ signal is aligned with a rising edge of the DQS signal), the DDRC starts to read data stored in a memory cell. On the contrary, in the data write scenario, after receiving the DQ signal of the DDRC, the DDR may compare the DQ signal with the DQS signal. When a center of the DQ signal is aligned with a center of the DQS signal (for example, a pulse center of the DQ signal is aligned with a pulse center of the DQS signal), the DDR starts to write data to the memory cell. In addition, the DDRC 0 may be further connected to each memory cell in the DDR 11 and the DDR 12 through the control address line, and the DDR 1 may be further connected to each memory cell in the DDR 13 and the DDR 14 through the control address line. The control address line is configured to perform transmission of a control address (control address, CA) signal. The control address line generally includes a row control address line and a column control address line. For example, it is assumed that there are M rows and N columns of memory cells. In this case, the control address line may include M row control address lines and N column control address lines. When data in a specific memory cell needs to be read/written, the DDR may first send a valid level on a row control address line of a row in which the memory cell is located, to drive the row on which the memory cell is located to be enabled, and then send a valid level on a column control address line of a column in which the memory cell is located, to drive the memory cell to be enabled. In this case, the DDR can read/write the data in the enabled memory cell. In this process, a CA signal on a row control address line of a row in which a memory cell to be read/written is located and a CA signal on a column control address line of a column in which the memory cell to be read/written is located are presented as the valid level, and a CA signal on a control address line other than the row and the column is presented as an invalid level. In some embodiments, the valid level may be a "1" level, and the invalid level is a "0" level. Alternatively, in some other embodiments, the valid level is a "0" level, and the invalid level is a "1" level.

It should be noted that, in addition to the CXL, the first integrated unit 43111 may further include other interfaces, for example, a clock interface b₂ and a status interface b₃. The clock interface b₂ may be connected to a clock pin a₂ on the gold finger connector 4312 through a reference clock signal line Ref_clk, and is configured to receive a reference clock signal transmitted through the clock pin a₂ on the gold finger connector 4312. The reference clock signal may be, for example, sent by a processor 411, and the first integrated unit 43111 may provide a reference clock for each component in the memory module 431 based on the received reference clock signal. The status interface b₃ may be connected to a management pin a₃ on the gold finger connector 4312 through an out-of-band management bus SMBUS, and is configured to receive a status request message transmitted through the management pin a₃ on the gold finger connector 4312. The status request message may be, for example, sent by the processor 411, and is used to obtain related status information of the memory module 431, for example, a temperature. In this case, the first integrated unit 43111 may obtain, based on the status request message, temperatures collected by the TMP 43161 and the TMP 43162 located at different positions of the memory module 431, and may return the temperatures or processed temperatures to the processor 411 through the SMBUS and the management pin a₃ on the gold finger connector 4312.

In addition, the first integrated unit 43111 may be further connected to the read/write status indicator 43151 through a line. When reading/writing data in the DDR 11 to the DDR 14, the first integrated unit 43111 may send an on indication to the read/write status indicator 43151, and may send an off indication to the read/write status indicator 43151 after reading/writing is completed, to notify an external person in time whether the memory module 431 is reading/writing by controlling whether the read/write status indicator 43151 is in an on state.

In addition, code or instructions for implementing the foregoing functions by the first integrated unit 43111 may be stored in the flash 4317. The first integrated unit 43111 is connected to the flash 4317 through a serial peripheral interface (serial peripheral interface, SPI), and obtains the code or instructions needed from the flash 4317 through the SPI when necessary, to perform the foregoing functions.

The second integrated unit 43112 may be connected to all control address lines in the memory module 431, and is configured to monitor CA signals on these control address lines in real time. When detecting that a level jump occurs in a CA signal on a specific control address line, the second integrated unit 43112 parses the jump, determines a memory cell accessed by the first integrated unit 43111 this time, and further determines a second storage address to which the memory cell belongs. In some scenarios, the second integrated unit 43112 may further store a second access frequency table. The second access frequency table includes a plurality of second storage addresses and corresponding access frequency. The plurality of second storage addresses are obtained by dividing the DDR 11 to the DDR 14. For example, it is assumed that the DDR 11 to the DDR 14 are 128 GB in total. 33554432 second storage addresses may be obtained through division in a manner of dividing one second storage address per 4 KB. The second integrated unit 43112 may update the second access frequency table in a periodic manner. In each periodicity, each time after determining that one second storage address is accessed, the second integrated unit 43112 may increase access frequency of the second storage address in the second access frequency table by 1 until a current periodicity ends, to obtain a second access frequency table corresponding to the current periodicity. The second integrated unit 43112 may be further connected to an out-of-band communication pin a₄ on the gold finger connector 4312 through an out-of-band communication bus. The out-of-band communication bus may be, for example, a Hisport bus shown in the figure. Correspondingly, the out-of-band communication pin a₄ on the gold finger connector 4312 is correspondingly a Hisport pin, and the Hisport pin may be further connected to a third integrated unit 421 in a media management board 420. After each periodicity ends, the second integrated unit 43112 may send the second access frequency table of the current periodicity to the third integrated unit 421 through the Hisport bus and the Hisport pin on the gold finger connector 4312. Then, the second integrated unit 43112 may refresh the second access frequency table, for example, reset access frequency of all second storage addresses in the second access frequency table to zero, and start an update operation of a second access frequency table of a next periodicity.

In addition to the serial pin a₁, the clock pin a₂, the management pin a₃, and the Hisport pin a₄ in the foregoing content, the gold finger connector 4312 may further include a power pin a₅. The power pin a₅ is connected to the PWR 4314 in the memory module 431, and is configured to: receive a power supply signal of 12 V transmitted by the processor 411, and provide the power supply signal for the PWR 4314. The PWR 4314 performs voltage division processing on the power supply signal of 12 V, to obtain a plurality of power supply sub-signals such as power supply sub-signals of 1.3 V and 1.2 V, and then separately provides the plurality of power supply sub-signals for the first integrated unit 43111, the second integrated unit 43112, and the DDR 11 to the DDR 14. The gold finger connector 4312 may further include a status control pin a₆. The status control pin a₆ is connected to the memory module indicator 43152. When the memory module 431 is faulty, the memory module indicator 43152 may receive, through the status control pin a₆ on the gold finger connector 4312, light-on indication information sent by the processor 411, and light up the memory module indicator 43152 based on the light-on indication information, to prompt a faulty state of the memory module 431 to the external person in time.

With reference to the foregoing description content of the components in the memory module 431, when implementing a cold and hot migration solution, the processor 411 may send a read/write request to the CXL of the first integrated unit 43111 through the serial pin a₁ on the gold finger connector 4312. The first integrated unit 43111 determines, based on the read/write request, a memory cell that needs to be accessed this time, and sends a read/write indication to a DDRC connected to a DDR in which the memory cell is located. The DDRC sends, based on the read/write indication, a CA signal to a control address line corresponding to the memory cell, and performs a read/write operation on data stored in the memory cell after the memory cell is enabled. After detecting that the CA signal changes, the second integrated unit 43112 determines the accessed memory cell based on the changed CA signal, updates access frequency of a second storage address to which the memory cell belongs in the second access frequency table of the current periodicity, continues to monitor the CA signal until the current periodicity ends, and sends a final second access frequency table to the third integrated unit 421 through the Hisport bus and the Hisport pin a₄ on the gold finger connector 4312. Subsequently, the third integrated unit 421 collects statistics on an access frequency table of each memory module and communicates with a fourth integrated unit 422, and sends second access frequency tables of all memory modules to the processor 411. The processor 411 performs statistical analysis on the second access frequency table of each memory module and access frequency of each first storage address in a server mainboard 410, and determines hot data in each memory module and cold data in the server mainboard 410. In addition, the processor 411 communicates with a first integrated unit in each memory module, so that an exchange operation between the hot data in each memory module and the cold data in the server mainboard 410 is implemented. For specific implementations of subsequent operations, directly refer to the content in FIG. 9. Details are not described herein again.

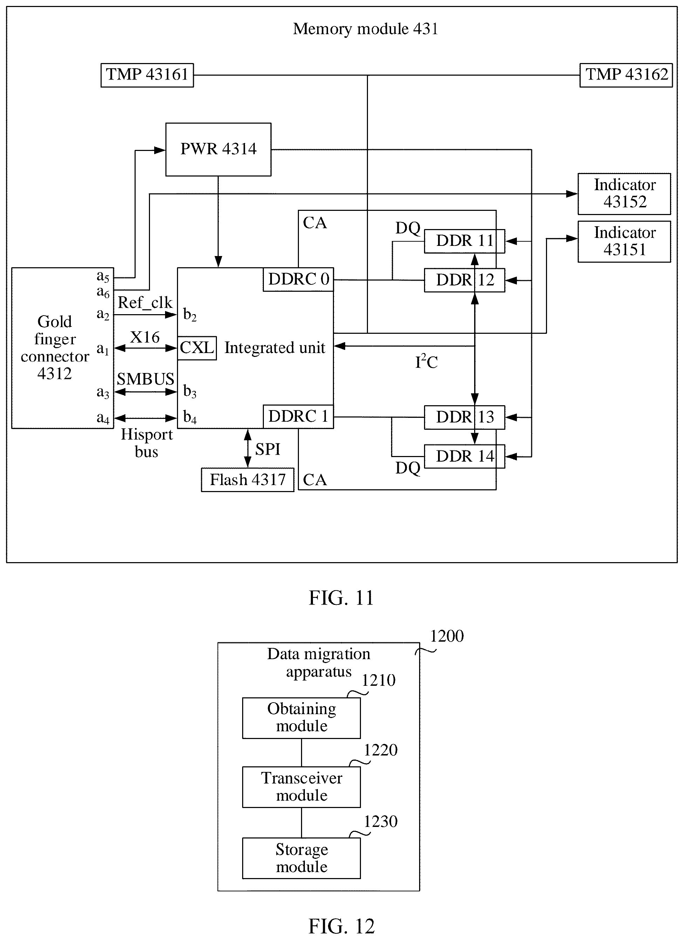

Similarly, when a server system uses the architecture shown in FIG. 5a, FIG. 11 is a diagram of an internal circuit of another memory module according to this application. A memory module 431 is still used as an example in the figure. In the memory module 431, in addition to including a clock interface b₂ and a status interface b₃, an integrated unit may further include a Hisport interface b₄. A Hisport pin a₄ on a gold finger connector 4312 is connected to the Hisport interface b₄ of the integrated unit through a Hisport bus. The integrated unit may send access frequency information of a current periodicity to the gold finger connector 4312 through the Hisport interface b₄, and then transmit the access frequency information to a media management board 420 through the gold finger connector 4312. For functions and connection relationships of the interfaces and the components in FIG. 11, refer to the foregoing descriptions of the interfaces and the components in FIG. 10. Details are not described herein again.

It may be understood that the foregoing descriptions are merely provided by using an example in which a redefinition solution of the gold finger connector or a cold and hot migration solution is applied in a server field. In an actual scenario, the redefinition solution of the gold finger connector may be applicable to any device that is connected through a gold finger connector and that has a power pin on the gold finger connector. By combining an original quantity of power pins into a smaller quantity of power pins, a larger power supply capability can be implemented, to further expand a specification of the device in which the gold finger connector is located. The cold and hot migration solution may be applicable to any solution that has two storage media. Hot data in a storage medium having a large access delay is migrated to a storage medium having a small access delay, and cold data in the storage medium having the small access delay is migrated to the storage medium having the large access delay, to quickly access the hot data and improve a storage capability of the storage medium in which the hot data is located, and improve storage performance of a storage device having two storage media.

Based on the foregoing described structure and function principle of the memory module, this application may further provide a data migration method. The method may be performed by the memory module or electronic device (for example, a server). The method includes: obtaining a cold and hot migration instruction, where the cold and hot migration instruction carries cold data in a first storage address associated with a processor and/or address information of a second storage address associated with the memory module; sending hot data in the second storage address to the processor in the electronic device based on the address information of the second storage address carried in the cold and hot migration instruction; and storing, in the second storage address, the cold data in the first storage address carried in the cold and hot migration instruction.

Herein, "associated" may be understood as "logically connected" or "functionally accessible". For example, the first storage address associated with the processor is a storage address that can be directly accessed by the processor in an electronic device mainboard, for example, may be a storage address located in the electronic device mainboard. The storage address is directly connected to the processor in the electronic device mainboard, and internal data of the storage address may be directly accessed by the processor in the electronic device mainboard. Similarly, the second storage address associated with the memory module is a storage address that can be directly accessed by a processing module in the memory module, for example, may be a storage address located in the memory module. The storage address is directly connected to the processing module in the memory module, and internal data of the storage address may be directly accessed by the processing module in the memory module.

Optionally, before obtaining the cold and hot migration instruction, the method may further include: accessing one or more second storage addresses in the memory module, and sending access frequency information of each second storage address in the memory module to a media management board in the electronic device.

It should be noted that, for a specific implementation process of the method, refer to related description content in FIG. 9. Details are not described herein again.

According to the foregoing method, this application may further provide a data migration apparatus. FIG. 12 is a diagram of a possible structure of the data migration apparatus. The data migration apparatus 1200 may be a chip or a circuit. The data migration apparatus 1200 may correspond to the memory module in the foregoing method, for example, a processing module in the memory module, or a first integrated unit and the second integrated unit. The data migration apparatus 1200 may implement steps of the method corresponding to the first integrated unit and the second integrated unit in the embodiment shown in FIG. 9. As shown in FIG. 12, the data migration apparatus 1200 may include an obtaining module 1210, a transceiver module 1220, and a storage module 1230.

In this application, the obtaining module 1210 may obtain a cold and hot migration instruction, where the cold and hot migration instruction carries cold data in a first storage address associated with a processor and/or address information of a second storage address associated with the memory module. The transceiver module 1220 may send hot data in the second storage address to the processor in an electronic device based on the address information of the second storage address carried in the cold and hot migration instruction. The storage module 1230 may store, in the second storage address, the cold data in the first storage address carried in the cold and hot migration instruction.

For concepts, explanations, detailed descriptions, and other steps of the data migration apparatus 1200 that are related to the technical solutions provided in this application, refer to the descriptions of the content in the foregoing methods or other embodiments. Details are not described herein again.

It may be understood that, for functions of the modules in the data migration apparatus 1200, refer to implementation of corresponding method embodiments. Details are not described herein again.

It should be understood that division into the units of the data migration apparatus 1200 is merely logical function division. During actual implementation, all or some of the units may be integrated into one physical entity, or may be physically separated. This is not specifically limited.

In addition, based on the foregoing content, this application further provides an electronic device. The electronic device may be, for example, the server, or include the server. For example, in some embodiments, the electronic device may be a computer device having a display screen and a server. The computer device may further include a peripheral like a hard disk, a speaker, a microphone, a mouse, or a keyboard, or may further include a built-in device like a driver or an input/output interface.

This application further provides a chip. The chip may include any one or more modules of the processing module or the media management board, may include any one or more integrated units of the first integrated unit, the second integrated unit, the third integrated unit, and the fourth integrated unit, may further include a processor, or may further include an interface. Any one or more components are configured to read instructions through the interface, to perform the corresponding method in the embodiment shown in FIG. 9.

This application further provides a computer-readable storage medium. The computer-readable storage medium stores a computer program. When the computer program is run, the method performed by any component in the embodiment shown in FIG. 9 is implemented.

This application further provides a computer program product. When the computer program product runs, the method performed by any component in the embodiment shown in FIG. 9 is implemented.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory module, comprising a processing module and a gold finger connector connected to the processing module, wherein
the gold finger connector is configured to be plugged to a component outside the memory module, to implement a communication connection between a component in the memory module and the component outside the memory module; and
the processing module is configured to: receive a read/write request from the component outside the memory module through the gold finger connector, access at least one storage medium in the memory module based on the read/write request, and transmit, to the component outside the memory module through the gold finger connector, access frequency information of each storage address corresponding to at least one storage medium in the memory module within a preset time period, wherein the access frequency information of each storage address is used by the component outside the memory module to migrate data stored in a storage address whose access frequency is greater than a hotness threshold to a storage medium connected to a processor.

2. The memory module according to claim 1, wherein the processing module comprises a first integrated unit and a second integrated unit, the first integrated unit is connected to at least one storage medium in the memory module, and the gold finger connector is connected to the first integrated unit and the second integrated unit;
the first integrated unit is configured to: receive the read/write request from the component outside the memory module through the gold finger connector, and access at least one storage medium in the memory module based on the read/write request; and
the second integrated unit is configured to send, to the component outside the memory module through the gold finger connector, the access frequency information of each storage address corresponding to at least one storage medium in the memory module within the preset time period.

3. The memory module according to claim 2, wherein one or more reserved pins of the gold finger connector are defined as an out-of-band communication pin, and the second integrated unit is connected to the out-of-band communication pin through an out-of-band communication bus; and
the second integrated unit is configured to send the access frequency information of each storage address to the gold finger connector through the out-of-band communication bus and the out-of-band communication pin.

4. The memory module according to claim 3, wherein the out-of-band communication pin transmits the access frequency information by using a differential signal, a pin B68 and a pin B69 of the gold finger connector are defined as two transmit pins, and a pin A68 and a pin A69 of the gold finger connector are defined as two receive pins; and
the second integrated unit is configured to: send the access frequency information of each storage address to the gold finger connector through the pin B68 and the pin B69, and receive returned information of the gold finger connector through the pin A68 and the pin A69.

5. The memory module according to any one of claims 2 to 4, wherein the memory module further comprises a control address line, and the first integrated unit is connected to at least one storage medium in the memory module through the control address line;
the first integrated unit is specifically configured to access at least one storage medium in the memory module by adjusting a control address CA signal on the control address line; and
the second integrated unit is specifically configured to determine, based on a change of the CA signal on the control address line, the access frequency information, within the preset time period, of the storage address corresponding to at least one storage medium in the memory module in which the second integrated unit is located.

6. The memory module according to claim 1, wherein the processing module comprises one integrated unit, and the integrated unit is connected between at least one storage medium in the memory module and the gold finger connector.

7. The memory module according to any one of claims 2 to 6, wherein a first positive pin exists in a region in which a pin B1 to a pin B6 of the gold finger connector are located, a first ground pin exists in a region in which a pin A1 to a pin A6 of the gold finger connector are located, widths of the first positive pin and the first ground pin are both greater than a preset width, and the preset width is a width of an original pin defined in a standard.

8. The memory module according to claim 7, wherein the preset width is K, and the widths of the first positive pin and the first ground pin are both 11K.

9. The memory module according to claim 7, wherein there are two first positive pins, and there are two first ground pins; and if the preset width is K, widths of each first positive pin and each first ground pin are both 5K, or widths of one first positive pin and one first ground pin are 7K, and widths of the other first positive pin and the other first ground pin are 3K.

10. The memory module according to claim 7, wherein there are three first positive pins, and there are three first ground pins; and if the preset width is K, widths of each first positive pin and each first ground pin are both 3K.

11. The memory module according to any one of claims 7 to 10, wherein the first positive pin and the first ground pin are implemented by gold-plated copper.

12. An electronic device, comprising the memory module according to any one of claims 1 to 11.

13. The electronic device according to claim 12, further comprising an electronic device mainboard and a media management board, wherein the electronic device mainboard comprises a processor and at least one first storage medium, the memory module comprises at least one second storage medium, a quantity of memory modules is N, and N is a positive integer, wherein
any memory module is configured to send access frequency information of each second storage address corresponding to at least one second storage medium in the memory module within a preset time period to the media management board;
the media management board is configured to send access frequency information of each second storage address corresponding to each second storage medium in the N memory modules within the preset time period to the processor; and
the processor is configured to: migrate, based on access frequency information of each first storage address corresponding to the at least one first storage medium within the preset time period and the access frequency information of each second storage address corresponding to each second storage medium in the N memory modules within the preset time period, data stored in a target second storage address whose access frequency is greater than a hotness threshold to the first storage medium, and migrate data stored in a target first storage address whose access frequency is less than a coldness threshold to the second storage medium.

14. The electronic device according to claim 13, wherein a processing module in the any memory module comprises a first integrated unit and a second integrated unit;
the first integrated unit in the any memory module is configured to access the at least one second storage medium in the memory module in which the first integrated unit is located; and
the second integrated unit in the any memory module is configured to send, to the media management board, the access frequency information, within the preset time period, of each second storage address corresponding to the at least one second storage medium in the memory module in which the second integrated unit is located.

15. The electronic device according to claim 13 or 14, wherein the media management board comprises a third integrated unit and a fourth integrated unit, the third integrated unit is separately connected to the fourth integrated unit and the second integrated unit in each memory module, and the fourth integrated unit is further connected to the processor;
the third integrated unit is configured to: receive the access frequency information that is sent by the second integrated unit in each memory module and that is of each second storage address in the memory module within the preset time period, collect the access frequency information of each second storage address in the N memory modules within the preset time period, and send the collected access frequency information to the fourth integrated unit; and
the fourth integrated unit is configured to send the collected access frequency information of each second storage address in the N memory modules within the preset time period to the processor.

16. A data migration method, wherein the method is performed by the memory module according to any one of claims 1 to 11, or the method is performed by the electronic device according to any one of claims 12 to 15, and the method comprises:
obtaining a cold and hot migration instruction, wherein the cold and hot migration instruction carries at least one of cold data in a first storage address associated with a processor or address information of a second storage address associated with the memory module;
sending hot data in the second storage address to the processor in the electronic device based on the address information of the second storage address carried in the cold and hot migration instruction; and
storing, in the second storage address, the cold data in the first storage address carried in the cold and hot migration instruction.
